Europäisches Patentamt

European Patent Office

Office européen des brevets

(19)

(11) Veröffentlichungsnummer: **0 085 066 B1**

(12) # EUROPÄISCHE PATENTSCHRIFT

(45) Veröffentlichungstag der Patentschrift:
08.10.86

(21) Anmeldenummer: 82902250.8

(22) Anmeldetag: 29.07.82

(86) Internationale Anmeldenummer:
PCT/DE 82/00158

(87) Internationale Veröffentlichungsnummer:
WO 83/00570 (17.02.83 Gazette 83/5)

(51) Int. Cl.⁴: **G 03 F 5/24, B 41 M 3/14,
B 44 F 1/12, B 42 D 15/00**

(54) **VERFAHREN ZUR AUFRASTERUNG VON HALBTONBILDMOTIVEN.**

(30) Priorität: 30.07.81 DE 3130182
30.07.81 DE 3130183

(43) Veröffentlichungstag der Anmeldung:
10.08.83 Patentblatt 83/32

(45) Bekanntmachung des Hinweises auf die Patenterteilung:
08.10.86 Patentblatt 86/41

(84) Benannte Vertragsstaaten:
AT BE CH DE FR GB LI LU NL SE

(56) Entgegenhaltungen:
GB - A - 2 085 360

Lehrbuch der Druckindustrie, 4 Aufl. 1979, Bd. 2, S. 163-179

(73) Patentinhaber: GAO Gesellschaft für Automation und Organisation mbH, Euckenstrasse 12,
D-8000 München 70 (DE)

(72) Erfinder: MÜLLER, Hans, Hippelstrasse 23,
D-8000 München 80 (DE)
Erfinder: MAY, Stefan, Daphnestrasse 17,
D-8000 München 81 (DE)

(74) Vertreter: Klunker, Hans-Friedrich, Dr. et al,
Patentanwälte Klunker . Schmitt-Nilson . Hirsch
Winzererstrasse 106, D-8000 München 40 (DE)

## Beschreibung

Die Erfindung betrifft ein Verfahren zur Herstellung von aufgerasterten Bildmotiven, bei dem die Grauwerte eines Halbtonbildmotivs durch Veränderung einer Rastergrundstruktur wiedergegeben werden.

Insbesondere bei der Herstellung von Wertpapieren, Sicherheitsdrucken, Ausweiskarten und dergleichen ist die Verwendung von Sicherheitslinienmustern, wie z.B. Guillochen, seit langem bekannt, um Nachahmungen oder Verfälschungen derartiger Aufzeichnungsträger zu verhindern. Zu schützendes Bildmotiv und Sicherheitslinienmuster werden dabei als separate Elemente benutzt. In der CH-PS 477 066 ist beispielsweise eine Ausweiskarte beschrieben, bei der mittels eines Guillochenüberdrucks ein in der Ausweiskarte vorgesehenes Lichtbild des Karteninhabers vor Manipulationen gesichert wird.

Die Herstellung von Sicherheitsdrucken nach diesem Verfahren ist relativ einfach und billig durchzuführen, da das Sicherheitsmuster ohne irgendwelche Zusatzmassnahmen grossflächig über das Bildmotiv gedruckt wird. Als nachteilig erweist sich jedoch, dass an den Bereichen, in denen Bildmotiv und Sicherheitslinien übereinander gedruckt sind, Farbmischungen entstehen, die die farbliche Kontinuität der Linie stören.

Bei einfarbiger Ausführung von Bildmotiv und Linienmuster sowie bei sehr dunklen Bildmotiven sind im Bereich des Bildmotivs die Sicherheitslinien entweder überhaupt nicht oder nur sehr schlecht zu erkennen. Derartige Sicherungstechniken werden deshalb nur für qualitativ einfache Sicherheitsdrucke verwendet.

Zur Vermeidung derartiger Nachteile ist es insbesondere beim Banknotendruck üblich, Bildmotive in Aussparungen oder Fenster des Guillochen-Untergrunddruckes einzusetzen. Die Bildmotive sind dabei in der Regel in hochwertigem Stahltiefdruck ausgeführt, der in sich trotz Fehlen des Guillochenmusters im Bildmotiv einen hohen Fälschungsschutz bietet. Nachteilig ist es allerdings, dass der Flächenanteil des Bildmotivs die für den Untergrunddruck verwendbare Fläche reduziert und dass dadurch der durch Guillochenuntergrundmuster mögliche Fälschungs- und Verfälschungsschutz bei grösser werdenden Bildmotiven sehr wesentlich reduziert wird. Die Einhaltung von vorhandenen Sicherheitsrichtlinien (Börsenrichtlinien), in denen unter anderem ein prozentualer Mindestflächenanteil für den Guillochen-Untergrund gefordert ist, lässt die Verwendung ganzflächiger Bildmotive für an diese Richtlinien gebundene Wertdrucke nicht zu.

Unter Umgehung einiger Nachteile des erstgenannten Verfahrens, bei dem das Bildmotiv mit dem Sicherheitsmuster überdruckt ist, wurde für die Herstellung von Ausweiskarten ein weiteres Verfahren bekannt, mit dem Fotografien selbst in schwarzen Bereichen des Fotos durch klar erkennbare Guillochenlinien absicherbar sind (siehe DE-B-2 907 809).

Zur besseren Erkennbarkeit des Sicherheitsmusters wurde dabei vorgeschlagen, den Fotobereich bereits vor der Belichtung mit einem Sicherheitsmuster zu versehen, so dass nach der Belichtung die belichteten Bereiche des Bildmotivs durch ein unbelichtetes Sicherheitsmuster unterbrochen und damit die Linien des Guillochenmusters unverändert gut erkennbar sind.

Trotz der eindeutigen Vorteile dieses Verfahrens erweist es sich als nachteilig, dass diese Technik nur im Zusammenhang mit fotografisch aufgebrachten Bildmotiven möglich ist. Die Ausnutzung der Vorteile bei anderen Aufzeichnungsträgern ohne fototechnische Massnahmen ist nicht möglich.

Gemäss einem neuartigen Verfahren wurde bereits vorgeschlagen, Sicherheitslinienmuster in Bildmotive auf Wertpapieren bzw. Aufzeichnungsträgern zu integrieren. Dabei wird das aufgedruckte Bildmotiv von einem ebenfalls aufgedruckten Linienmuster überlagert, wobei das Bildmotiv durch eine an das Linienmuster angepasste Negativkontur unterbrochen und das Linienmuster kongruent eingedruckt wird. Je nach Ausführungsform können die Linien der Negativkontur genauso breit wie die Linien des Linienmusters sein oder aber auch breiter, so dass die Sicherheitslinien jeweils zu beiden Seiten einen geringen Abstand zum Bildmotiv aufweisen und damit das Bildmotiv ohne Berührung als freie Linien durchlaufen.

Dieses Verfahren zeichnet sich dadurch aus, dass es bei der Herstellung der Aufzeichnungsträger ohne fotografische Techniken auskommt und insbesondere für die Herstellung von Wertdrucken neue Möglichkeiten eröffnet, da nun selbst einfachste Bildmotive völlig unabhängig von der Bildgrösse, d.h. also auch gross- oder ganzflächig, sicherheitstechnisch hochwertig und den Börsenrichtlinien entsprechend ausgeführt werden können. Bei Anwendung der im Wertpapierdruck üblichen Drucktechniken lassen sich die Sicherheitslinien und Negativkonturen sehr fein ausführen, so dass man bei Ausnutzung der farbtechnischen Möglichkeiten Wertpapiere erhält, deren Nachahmung oder Reproduktion sehr erschwert bzw. mit einfachen Hilfsmitteln unmöglich ist.

Während die obengenannten Verfahren zur Herstellung von Aufzeichnungsträgern Bildmotiv und Sicherheitslinienmuster letzten Endes als separate Elemente verwenden, sind auch Verfahren bekannt, bei denen die Bildinformation durch in der Linienbreite variierende Sicherheitslinien erzeugt wird. Diese Verfahren beruhen auf der in der Druck- und Reprotechnik bekannten Verwendung von Glasgravur- bzw. Distanz- und Kontaktrastern zur Aufrasterung einer Bildinformation. Handels- und gebrauchsüblich sind verschiedene Rasterformen, wie z.B. Punkt-, Kreuz-, Linien oder Kornraster, wobei kennzeichnend für die Rasterformen ist, dass sie aus einfachen, regelmässigen geometrischen Strukturen (Punkt-, Kreuz-, Linienraster) oder aus statistisch gleichverteilten unregelmässigen Strukturen (Kornraster) bestehen. Die Variation derartiger Rasterformen ist durch die Herstellungsmöglichkeiten beschränkt.

Ausgangsbasis bei der Herstellung der heute weitverbreiteten Kontaktraster sind die Distanz- oder Glasgravurraster.

Die Herstellung von Glasgravurrastern ist aufwendig und kostenintensiv, was der Herstellungsweg deutlich macht. Ausgangspunkt sind zwei absolut planparallele Glasplatten, die mit einer flusssäurefesten Schicht überzogen werden und in die anschliessend mit dem Diamantschaber einer Linienmaschine die Linienweite in die ätzfeste Schicht eingeritzt wird. Nachdem die Linien mit Flusssäure tiefgeätzt worden sind, wird die flusssäurefeste Schicht entfernt und die vertieften Linien werden mit schwarzer Farbe eingefärbt. Der Kreuzlinieneffekt des Rasters entsteht dann dadurch, dass die beiden Linienrasterplatten Gravur auf Gravur in einem Winkel von 90° miteinander verkittet werden. Da aufgrund des Ätzens der Linien leicht eine Abweichung vom beabsichtigten Linienverhältnis eintreten kann, sind die Arbeitsergebnisse mit verschiedenen Rastern gleicher Rasterweite mitunter oft recht unterschiedlich, insbesondere lässt sich die Linienbreite bei der Herstellung von Linienrastern nur innerhalb bestimmter Toleranzen steuern. Weiter ist aufgrund der Herstellungsweise auch ersichtlich, dass keine komplizierten Rasterstrukturen, wie z.B. sich mehrfach kreuzende und ineinander verschlungene Linien oder andere komplizierte unregelmässige Rasterstrukturen, herstellbar sind. Möglich sind nur im wesentlichen parallele, in eine Richtung verlaufende, auf einer Glasplatte sich nicht kreuzende Linienscharen.

Ausgehend von einem Glasgravurraster werden Kontaktraster hergestellt, indem man feinstkörnige Halbtonemulsionen in einer bestimmten Distanz hinter einem Glasgravurraster belichtet und anschliessend entwickelt.

Von einem Glasgravurraster lassen sich unbeschränkt hohe Stückzahlen von Kontaktrastern herstellen, wodurch die durch den teuren und aufwendigen Herstellungsprozess des Glasgravurrasters entstehenden Kosten für den Anwender erheblich reduziert werden können. Für die möglichen Rasterstrukturen bei auf diese Weise hergestellten Kontaktrastern gelten wegen des als Ausgangsraster verwendeten Glasgravurrasters dieselben Einschränkungen und Grenzen wie für die Glasgravurraster.

Die Aufrasterung eines Halbtonbildmotivs mit einem Kontaktraster, der einen kontinuierlichen Gradationsverlauf aufweist, geschieht dadurch, dass man ein Strichmaterial mit einem nahezu digitalen Gradationsverlauf durch das Negativ bzw. Positiv des Halbtonmotivs und den Kontaktraster belichtet, wobei Halbtonnegativ bzw. -positiv und Kontaktraster in direktem Kontakt auf dem Strichmaterial aufliegen. Im Strichmaterial bildet sich dann durch die Belichtung je nach der vom Halbtonnegativ bzw. -positiv durchgelassenen Lichtmenge die verwendete Rasterstruktur ab, welche die Bildinformation durch sich verdickende bzw. verjüngende Rasterstrukturen wiedergibt.

Das gleiche Ergebnis, jedoch mit grösserem arbeitstechnischen Aufwand, erzielt man, wenn man das Bildmotiv direkt mit einem Glasgravurraster aufrastert. Dazu wird das Strichmaterial durch das Halbtonnegativ bzw. -positiv des Bildmotivs, eine geeignet zu wählende Blende und den Glasgravurraster belichtet, wobei die Abstände zwischen Strichmaterial und Raster und zwischen Raster und Blende genau aufeinander abgestimmt werden müssen.

Bei beiden Rastertypen erreicht man eine stufenlose Wiedergabe von Halbtönen.

Ein anderes Verfahren zur Herstellung eines bestimmten Kontaktrasters, das nicht auf Glasgravurrastern beruht und bei dem der Kontaktraster eine stufenförmige Gradation aufweist, ist in der DE-C-166 722 beschrieben worden. Dabei wird von einem Schwarzweissraster, der aus hellen und dunklen gradlinigen Streifen besteht, eine fotografische Reproduktion in der Form hergestellt, dass während der Belichtung das Objektiv der Kamera senkrecht zur Linienrichtung ein- oder mehrmals in so geringem Masse verschoben wird, dass die neuen Rasterbilder nur um einen Teil der Linienbreite gegen das erste verrückt erscheinen. Es entstehen so Streifen von abgestufter Deckung. Die so fabrizierten Raster liefern als Kontaktraster eine gestufte Wiedergabe von Halbtönen. Nachteilig bei diesem Verfahren ist allerdings neben dem mechanisch sehr aufwendigen Herstellverfahren, dass sich nur gerade parallele Linien sinnvoll in Stufenraster umsetzen lassen.

Die Verwendung von Linienrastern bei der Herstellung von Wertpapieren ist schon aus der DE-C 368 134 bekannt. Dabei wird die Bildwirkung ganz oder teilweise durch parallele oder nahezu parallele, unter Benutzung eines Glasgravurrasters hergestellte, gerade oder krumme Linien hervorgebracht, die sich mit zunehmender Tonung des Bildes kontinuierlich verbreitern und in den dunkelsten Partien zusammenschliessen. Von der auf diese Weise umgesetzten Haltbonvorlage werden mit den üblichen fotomechanischen Verfahren Druckplatten hergestellt.

Nachteilig bei diesem Verfahren ist, dass es den mit der Herstellung von Glasgravurrastern verbundenen Grenzen und Einschränkungen unterworfen ist. So lassen sich z.B. nur einfache Rasterstrukturen aus parallelen oder nahezu parallelen Linien herstellen, die sich in den dunkelsten Bereichen zusammenschliessen und verklumpen können. Komplizierte Rasterstrukturen, wie sich mehrfach kreuzende, ineinander verschlungene Linienmuster oder etwa die sicherungstechnisch hochwertigen Guillochen oder unregelmässige, beliebig komplizierte Strukturen, lassen sich auf diese Weise nicht herstellen. Auch die Verwendung von Kontaktrastern würde diesen Tatbestand nicht ändern, da deren Herstellung ebenfalls auf Glasgravurrastern beruht. Der sicherungstechnische Wert bei Verwendung paralleler oder nahezu paralleler Linien wäre wegen der trotz allem noch bestehenden Fälschungs- und Verfälschungsmöglichkeiten als nicht besonders hoch zu veranschlagen.

Die Aufgabe der Erfindung ist es daher, ein Verfahren zur Herstellung eines aufgerasterten Bildmotivs zu schaffen, welches nicht den mit der Herstellung klassischer Kontaktraster verbundenen Grenzen unterworden ist.

Diese Aufgabe wird durch die im Anspruch 1 bzw. im Ansprüch 16 gekennzeichneten Verfahrensschritte gelöst. Die Lösung beruht somit auf dem Grundgedanken, nicht wie in der bekannten Rastertechnik den gesamten Grauwertbereich des aufzurasternden Halbtonbildmotivs in einem Schritt mit einem klassisch hergestellten Kontaktrasters aufzurastern – wobei die Zuordnung von jeweiligem, lokal vorliegendem Grauwert des Halbtonbildmotivs zu lokaler Strukturstärke des Rasters nicht beeinflussbar ist und die Form der Raster den herstellungstechnischen Grenzen unterworfen ist –, sondern den Grauwertumfang des aufzurasternden Halbtonbildmotivs in Bereiche einzuteilen, deren Grenzen beliebig definierbar sind, sämtlichen oder ausgewählten dieser Grauwertbereiche eine bestimmte, jedoch frei definierbare Strukturstärke eine der Form nach beliebigen Rasterstruktur zuzuordnen und die Anteile des Halbtonbildmotivs, welche einen Grauwert aus einem dieser Bereiche aufweisen, lokal in die diesem Grauwertbereich zugeordnete Rasterstrukturstärke umzusetzen.

In einer Weiterbildung der Erfindung wird der Grauwertumfang des Halbtonbildmotivs nicht in Bereiche aufgeteilt, sondern es wird jedem Grauwert eine bestimmte Rasterstrukturstärke zugeordnet.

Zur Terminologie sei angemerkt, dass der Begriff «Grauwert» als äquivalent zu den in der Foto- und Reprotechnik gebräuchlichen Begriffen wie «Gradation», «Schwärzung», «Dichte» («Grauwert» = log (Opazität)) anzusehen ist und in diesem Zusammenhang auch stellvertretend für diese Begriffe benutzt wird, da das erfinderische Verfahren nicht auf Schwarzweiss-Motive begrenzt ist und analog auch auf farbige Bildmotive übertragen werden kann.

Die Lösung der Aufgabe der Erfindung wurde durch verschiedene fototechnische Verfahren erzielt, die jedoch auch in eine «technisierte» Variante unter Verwendung eines Scanners, einer EDV-Anlage und eines EDV-gesteuerten Lasers umgesetzt werden können. Die Grundzüge der Erfindung werden im folgenden zuerst anhand der fototechnischen Verfahren erläutert.

Beim ersten fototechnischen Verfahren, im folgenden «Einzelstufen-Tonwert-Verfahren» genannt, werden von dem aufzurasternden Halbtonbildmotiv Tonwertauszüge hergestellt, von denen jeder die Anteile des Halbtonbildmotivs wiedergibt, welche Grauwerte aus einem durch die Belichtungszeit auf der Grauwertskala genau einstellbaren Grauwertbereich wiedergeben.

Von einer Rastergrundstruktur, welche eine beliebige Form haben kann – z.B. ein kompliziertes Linienmuster aus sich kreuzenden und verschlingenden Linien, Buchstabenfolgen, Zahlen oder auch Strichrepos von reich strukturierten Landschaftsmotiven und nicht zuletzt klassische Rasterformen –, werden Strichrepros wachsender Strukturstärke, d.h. schrittweise aufgeweitete Rasterstrukturen, hergestellt, entweder auf grafischem Weg oder durch Auflegen eines Negativfilms der Grundrasterstruktur auf ein Strichmaterial und gezieltes Überstrahlen, wobei für jeden Überstrahlungsvorgang ein neues Strichmaterial verwendet wird und die Belichtungszeit entsprechend der gewünschten Aufweitung der Rasterstruktur erhöht wird. Die Anzahl der derartig hergestellten aufgeweiteten Rasterstrukturen entspricht der Anzahl der zuvor erstellten Tonwertauszüge des Halbtonbildmotivs und damit der Anzahl der umzusetzenden Grauwertbereiche. Der weitere Umsetzungsprozess des Halbtonbildmotivs in ein aufgerastertes Bildmotiv geschieht derart, dass ein Negativfilm der Rasterstruktur mit der grössten Strukturstärke, d.h. der grössten Aufweitung gegenüber der Grundrasterstruktur, zusammen mit einem Negativfilm des Tonwertauszugs des Halbtonbildmotivs der geringsten Strukturstärke – der Tonwertauszug mit der geringsten Strukturstärke gibt die Anteile des Halbtonbildmotivs wieder, welche die dunkelsten Grauwerte aufweisen, wobei die Grenze dieses Grauwertbereichs durch die Belichtungszeit bei der Herstellung der Tonwertauszüge festgelegt wurde – in Kontaktanordnung auf ein unbelichtetes Strichmaterial gelegt werden, diese Anordnung solange belichtet wird, bis in den Bereichen des Strichmaterials, wo die Anordnung aus Negativfilm der Rasterstruktur grösster Strukturstärke und Negativfilm des Tonwertauszugs geringster Strukturstärke vollkommen lichtdurchlässig ist, eine vollständige Schwärzung erfolgt ist, so dass der durch den Tonwertauszug bestimmte Grauwertbereich des Halbtonbildmotivs, d.h. hier die dunkelsten Grauwerte, in dem belichteten Strichmaterial durch das Raster mit der grössten Strukturstärke wiedergegeben wird.

Mit den folgenden Rasterstrukturen abnehmender Strukturstärke und den Tonwertauszügen wachsender Strukturstärke und jeweils einem neuen Strichmaterial wird analog verfahren.

Als Ergebnis erhält man dann ein vollständig aufgerastertes Halbtonbildmotiv, wobei die unterschiedlichen Grauwerte des Halbtonbildmotivs in aufgerasterter Form auf den verschiedenen Strichmaterialien vorliegen. Diese Strichmaterialien können entweder zur vollständigen Bildinformation zusammenkopiert und zur Herstellung einer Druckplatte verwendet werden, oder es wird jedoch Strichmaterial zur Herstellung einer separaten Druckplatte verwendet, so dass jeder Grauwertbereich des Halbtonbildmotivs in aufgerasterter Form separat gedruckt werden kann. Natürlich ist es auch möglich, nur bestimmte Strichmaterialien zusammenzukopieren, damit eine Druckplatte herzustellen und die restlichen Strichmaterialien zur Herstellung separater Druckplatten zu verwenden. Verwendet man ein Sicherheitslinienmuster aus Guillochen als Grundrasterstruktur, ist es besonders sinnvoll, diese Grundrasterstruktur zusätzlich in eines dieser Strichmaterialien oder in das vollständig aufgerasterte Halbtonbildmotiv einzukopieren oder von diesem eine separate Druckplatte herzustellen, so dass im aufgerasterten oder gedruckten Bildmotiv der Linienverlauf des Guillochmusters in allen Bildpartien ohne Unterbrechung sichtbar und verfolgbar ist.

Besondere Effekte lassen sich dadurch erzielen, wenn man die auf verschiedenen Druckplatten vorliegenden aufgerasterten Grauwertbereiche des Halbtonbildmotivs in verschiedenen Farben druckt, so dass verschiedene Grauwertbereiche nicht nur durch unterschiedliche Rasterstärken, sondern auch durch unterschiedliche Farben wiedergegeben werden. Der Querschnitt durch eine derartige gedruckte Rasterlinie weist dann einen stufenpyramidenartigen, aus verschiedenen Farbschichten bestehenden Verlauf auf, wobei die Anzahl der Stufen proportional zur Breite der Rasterlinie und damit zum Grauwert des Halbtonbildmotivs in diesem Bereich ist. Die Verwendung metallischer, metamerer, thermo- oder fotochromer Farben bietet mit diesem Verfahren völlig neue Möglichkeiten für die Erhöhung der Fälschungs- oder Verfälschungssicherheit von Wertpapieren oder Banknoten.

Ein weiterer Vorteil dieses Verfahrens ist es, dass sich damit jede beliebige Struktur als Rastergrundstruktur verwenden lässt, so dass damit die früheren, mit der Herstellung klassischer Raster wie Punkt-, Linien-, Kreuz- oder Kornraster verbundenen Grenzen bedeutungslos werden. Als Rastergrundstruktur lassen sich z.B. verwenden: parallele, nahezu parallele, spiralförmige, sternförmige, sich kreuzende oder verschlingende Liniensysteme mit zickzackartigem, wellen-, bogen-, kreisförmigem oder geradem Verlauf; Guillochen, z.B. auch zentrische Guillochen; Worte, Zahlen, Schriftzeichen; geometrische Strukturen wie Kreise, Ellipsen, Dreiecke, andere Vielecke; klassische Rasterstrukturen wie Punkt-, Linien-, Kreuz- oder Kornraster; Strukturelemente eines zweiten Bildmotivs, z.B. das Strichrepro eines reichstrukturierten Landschaftsmotivs; ein aufgerastertes Bildmotiv.

Ebenfalls vorteilhaft ist es, dass die Umsetzung Grauwert der Halbtonvorlage in eine bestimmte Rasterstrukturstärke gezielt steuerbar ist, sowohl was Anzahl und Umfang der umzusetzenden Grauwertbereiche betrifft, wie auch die jedem Grauwertbereich zugeordnete Rasterstrukturstärke. Je nach Anzahl der in Lage und Umfang auf der Grauwertskala beliebig definierbaren umzusetzenden Grauwertbereiche des Halbtonbildmotivs lässt sich eine stufenförmige bis kontinuierliche Grauwertwiedergabe durch eine stufenförmige bis kontinuierliche Aufweitung der Rastergrundstruktur erzielen. In diesem Zusammenhang bietet es sich auch an, sich die Vorteile der Vergrösserungstechnik zunutze zu machen. Wenn es z.B. um die Wiedergabe extrem feiner Bildmotive geht oder sehr feine Rasterstrukturen als Rastergrundstruktur verwendet werden, ist es vorteilhaft, zur Erzielung einer sehr differenzierten Grauwertwiedergabe sämtliche Verfahrensschritte mit vergrösserten Negativen bzw. Positiven durchzuführen und erst am Schluss die gerasterte Druckvorlage auf das gewünschte Mass zu verkleinern. Soll z.B. etwa der Grauwertverlauf der Vorlage in 50 Stufen wiedergegeben werden, so werden von der Grundrasterstruktur, die aus sehr feinen Guillochen oder anderen feinen Strukturen bestehen kann, 50 schrittweise aufgeweitete Rasterstrukturen in vergrössertem Massstab hergestellt. Vergrössert man das aufzurasternde Bildmotiv bzw. die Tonwertauszüge (in diesem Fall ebenfalls 50) entsprechend und führt dann sämtliche Verfahrensschritte mit diesen vergrösserten Strukturen durch, so werden damit Ungenauigkeiten in der Wiedergabe, die bei so grosser Stufenzahl beim Arbeiten in Normalgrösse auftreten können, auf Passschwierigkeiten zurückzuführen sind oder mit der endlichen Korngrösse des Fotomaterials und statistischen Schwankungen an den Randzonen der Strukturen zusammenhängen, umgangen oder auf ein Mindestmass reduziert. Auch der Vorteil bei der Herstellung der Rasterstrukturen ist dabei nicht ausser acht zu lassen, da sich gröbere Strukturen mit geringerem Aufwand herstellen und am Schluss besser verkleinern lassen als sehr feine Strukturen, die gleich in Originalgrösse produziert werden.

Beim Arbeiten mit sehr wenig Stufen, z.B. drei, ist es anderseits zur Verbesserung der optischen Qualität der Druckvorlage günstig, sämtliche Verfahrensschritte mit stark verkleinerten Rasterstrukturen durchzuführen. Dabei nutzt man die endliche Korngrösse des Fotomaterials und den nicht ganz stufenförmigen Gradationsverlauf des Strichmaterials aus, um den ansonsten scharfen Sprung zwischen zwei Graustufen in der gerasterten Druckvorlage etwas abzuschwächen und kontinuierlicher zu gestalten. Arbeitet man nämlich bei sämtlichen Verfahrensschritten in stark verkleinertem Massstab und vergrössert erst anschliessend die gerasterte Druckvorlage auf die gewünschte Grösse, so erhält man aufgrund des gerade erwähnten Effektes fast kontinuierliche Übergänge zwischen den verschiedenen, die unterschiedlichen Grauwerte des aufzurasternden Halbtonbildmotivs wiedergebenden Rasterstrukturstärken.

Ein etwas anderes Verfahren zur Verbesserung der optischen Qualität der Druckvorlage, das sich für jede Stufenzahl eignet und zusätzlich zu den gerade geschilderten Verfahren angewendet werden kann, besteht darin, das schon zusammenkopierte aufgerasterte Bildmotiv, jedoch noch ohne die zusätzlich einkopierte Rastergrundstruktur, in einer Reprokamera mit einer gewissen Unschärfe auf Strichmaterial zu reproduzieren. Die Unschärfe wird dabei so eingestellt, dass die stufenförmigen Übergänge im aufgerasterten Bildmotiv abgeschwächt und kontinuierlicher gestaltet werden. In dieses unscharf reproduzierte aufgerasterte Bildmotiv wird dann die schaft gezeichnete Rastergrundstruktur einkopiert.

Eine andere fototechnische Version des erfinderischen Verfahrens, das im folgenden sogenannte «Einzelstufen-Halbton-Verfahren», umgeht die Herstellung von Tonwertauszügen aus dem aufzurasternden Halbtonbildmotiv und verwendet statt dessen ein Negativ des Halbtonbildmotivs.

Die Verfahrensschritte bei diesem Verfahren verlaufen zum «Einzelstufen-Halbton-Verfahren» völlig analog, nur dass in diesem Fall bei den einzelnen Belichtungsvorgängen Tonwertauszug – Rasterstruktur – Strichmaterial die verschiedenen Tonwertauszüge durch das Halbtonnegativ des aufzurasternden Bildmotivs ersetzt werden, wobei hier der in die jeweilige Rasterstrukturstärke umzusetzende Grauwertbereich des Halbtonbildmotivs durch die Belichtungszeit eingestellt wird.

Eine weitere fototechnische Version ist das im folgenden sogenannte «Kontaktraster-Halbton-Verfahren», bei dem zuerst ein Kontaktraster hergestellt und anschliessend wie in der klassischen Rastertechnik das Halbtonbildmotiv aufgerastert wird. Der erfinderische Kern bei diesem Verfahren liegt in der Herstellung des Kontaktrasters, da hier die Herstellung von Glasgravurrastern und die damit verbundenen herstellungstechnischen Grenzen umgangen werden. Bei diesen Verfahren werden Negativfilme der schrittweise aufgeweiteten Rasterstrukturen der Reihe nach in Kontaktanordnung auf ein unbelichtetes Halbtonmaterial gelegt und eine bestimmte Zeitspanne lang belichtet, so dass nach Beendigung sämtlicher Belichtungsvorgänge mit den schrittweise aufgeweiteten Rasterstrukturen jedes Rasterelement der Grundrasterstruktur mit einem durch die einzelnen Belichtungszeiten definierten und genau einstellbaren Grauwert- bzw. Schwärzungsverlauf abgebildet wird. Verwendet man beispielsweise ein Sicherheitslinienmuster aus Guillochen als Rastergrundstruktur, so weist der Querschnitt durch ein Rasterelement, das heisst eine Linie, einen je nach Anzahl der aufgeweiteten Rasterstrukturen stufenförmigen bis kontinuierlichen Grauwert- bzw. Schwärzungsverlauf auf. Die Form dieser Schwärzungskurve kann durch Variation der Belichtungszeiten und Anzahl der aufgeweiteten Rasterstrukturen sowie durch den Grad der Aufweitung bei deren Herstellung gezielt und beliebig gesteuert werden, was bei der klassischen Kontaktrasterherstellung nicht möglich ist. In diesem so hergestellten Positivkontaktraster können Halbtonpositive wie in der klassischen Rastertechnik aufgerastert werden (Herstellung von Negativkontaktrastern analog durch Ersetzen von Positiven durch Negative u. umgekehrt). Mit diesem Verfahren lässt sich jede beliebige Struktur in einem Kontaktraster abbilden, der zur Aufrasterung eines Bildmotivs dienen kann. Vorteilhaft bei diesem Verfahren ist insbesondere die beliebige Steuerbarkeit des Grauwert- bzw. Schwärzungsverlaufs im Kontaktraster sowie die völlige Freiheit in der Wahl der Rastergrundstruktur. Die Grauwertwiedergabe bei der Aufrasterung eines Bildmotivs kann durch die Steuerung des Schwärzungsverlaufs im Kontaktraster beliebig eingestellt werden, bestimmte Grauwerte können unterdrückt, verschoben oder auch hervorgehoben werden (diese Steuerung der Grauwertwiedergabe ist natürlich auch mit den Einzelstufenverfahren möglich). Ein weiterer Vorteil dieses Verfahrens ist dessen Wirtschaftlichkeit – ganz im Gegensatz zur Herstellung von Glasgravurrastern, welche nur bei anschliessender Anfertigung einer grossen Anzahl von Kontaktrastern lohnend sind. Ausserdem eignen sich beide Verfahren, das Einzelstufen- wie das Kontaktrasterverfahren, besonders für den Wertpapierdruck, da hierfür zwar die Benutzung von Originalguillochen vorgeschrieben ist, die Mehrfachverwendung derselben Guillochenstruktur jedoch untersagt ist.

Ein wesentlicher Vorteil, insbesondere des Einzelstufenverfahrens, liegt darin, dass damit immer nur eine einzige Originaldruckvorlage geschaffen wird, da die eine identische Reproduktion ermöglichende Anfertigung eines Kontaktrasters umgangen wird und ein Nachvollziehen des Verfahrens sozusagen nur mit Kenntnis des genauen «Rezepts» (einzelne Belichtungszeiten, Strukturstärken der Strichrepros usw.) erfolgen kann. An dieser Stelle sei angemerkt, dass bei allen fototechnischen Varianten die Belichtungsreihenfolge beim Aufrasterungsprozess beliebig ist und nur der besseren Verständlichkeit wegen bei der Darstellung eine bestimmte Reihenfolge gewählt wurde. Ausserdem ist bei allen Varianten das Arbeiten mit Positiv- dem mit Negativfilmen äquivalent, so dass sämtliche Verfahren mit Positiv- oder Negativfilmen durchgeführt werden können. Mögliche Wechsel zwischen der Positiv- bzw. Negativarbeitsweise werden nicht explizit erwähnt, da sie für den Fachmann selbstverständlich sind.

Der Kern des erfindungsgemässen Verfahrens – oben wurden die fototechnischen Varianten erläutert – lässt sich jedoch auch in eine «technisierte» Variante umsetzen, wenn man sich die EDV-, Computergrafik-, Laser- und Scannertechnik zunutze macht.

Die wesentlichen Grundzüge einer solchen «technisierten» Variante werden im folgenden kurz skizziert, wobei man zwischen zwei etwas verschiedenen technisierten Verfahren unterscheiden muss: ein sogenanntes «EDV-Einzelstufen-Verfahren» und ein «EDV-Kontaktraster-Verfahren».

Zwischen fototechnischen und «technisierten» Varianten gibt es verschiedene Sprung- bzw. Überwechselmöglichkeiten, so dass man an verschiedenen Stellen die Verfahren kombinieren kann. Diese Schnittstellen werden im folgenden nicht besonders erwähnt, da sie aus dem Verfahrensablauf für den Durchschnittsfachmann klar ersichtlich sind.

Die wichtigsten technischen Geräte für die «technisierten» Verfahren bestehen aus einer EDV-Anlage und einem grafikfähigen Terminal, einer mit der EDV-Anlage verbundenen Scanningeinrichtung und einem durch die EDV-Anlage gesteuerten Laserstrahlschreiber.

Der erste Schritt der technisierten Verfahren besteht in der Erzeugung einer Rastergrundstruktur. Diese kann entweder mit den Hilfsmitteln der Computergrafik oder über geeignete mathematische Programme erzeugt werden, wobei die Form und Lage der Rasterelemente gespeichert werden, oder es wird eine geeignete, auf grafischem oder fototechnischem Wege erstellte Vorlage gescannt und die Form und Lage der Rasterelemente ebenfalls gespeichert.

Die schrittweise aufgeweiteten Rasterstrukturen können entweder mittels der EDV-Anlage aus der Rastergrundstruktur erzeugt, separat abgespeichert und optisch dargestellt werden, oder es werden fotografisch erstellte aufgeweitete Rasterstrukturen gescannt und gleichfalls separat abgespeichert.

Die EDV-technisch erzeugten aufgeweiteten Rasterstrukturen können auch über einen EDV-gesteuerten Laserstrahlschreiber auf ein Strichmaterial umgesetzt werden, indem der Laser mit den Informationen über Lage und Form der Rasterelemente der betreffenden Rasterstruktur gesteuert ein Strichmaterial belichtet.

Beim «EDV-Einzelstufen-Verfahren» werden vom aufzurasternden Halbtonbildmotiv «elektronische Tonwertauszüge» erstellt, in denen der gesamte Grauwertumfang der Halbtonvorlage nach Lage und Umfang in beliebig definierbare Grauwertbereiche aufgeteilt wird und die Halbtonvorlage für jeden Grauwertbereich separat derart gescannt wird, so dass die Anteile des Halbtonbildmotivs, welche einen Grauwert aus dem betreffenden Grauwertbereich aufweisen, nach Lage und Form gespeichert werden. Mittels der EDV-Anlage ordnet man jedem Grauwertbereich eine aufgeweitete Rasterstruktur zu, «überlagert» die gespeicherten Informationen über die Anteile des Halbtonbildmotivs aus dem betreffenden Grauwertbereich und die Informationen über die zugeordnete Rasterstruktur, in die dieser Grauwertbereich umgesetzt werden soll, derart, dass für jeden Punkt, an dem Rasterstruktur- und Bildmotivanteil vorliegt, eine resultierende Information abgespeichert wird. Diese resultierende Information gibt die in die betreffende Rasterstruktur umgesetzten Anteile des Bildmotivs aus dem ausgewählten Grauwertbereich wieder und kann optisch auf dem Bildschirm angezeigt oder über den EDV-gesteuerten Laser auf ein Strichmaterial übertragen werden. Dieses Verfahren wird für jeden Grauwertbereich und für jede diesem zugeordnete Rasterstruktur analog durchgeführt. Die bei diesen «elektronischen» Aufrasterungsprozessen entstehenden, für jeden Grauwertbereich separat gespeicherten, resultierenden Informationen können auch überlagert, gespeichert und optisch auf dem Bildschirm dargestellt werden, so dass man einen Eindruck über das insgesamt aufgerasterte Bildmotiv erhält. Über den mit diesen Informationen gesteuerten Laser kann das vollständig aufgerasterte Bildmotiv auch auf ein einziges Strichmaterial übertragen werden. Natürlich ist es auch möglich, mit Hilfe des EDV-gesteuerten Lasers das aufgerasterte Bildmotiv direkt entweder auf eine Druckplatte oder die einzeln aufgerasterten Grauwertbereiche auf verschiedene Druckplatten zu übertragen.

Beim «EDV-Kontaktraster-Verfahren» wird zuerst ein sogenanntes «elektronisches Kontaktraster» erzeugt. Dies geschieht z. B. dadurch, dass jeder der, wie oben beschrieben hergestellten, aufgeweiteten Rasterstrukturen ein Grauwert zugeordnet wird, diese Grauwertinformation der Information über Lage und Form der Rasterelemente der betreffenden Rasterstruktur zugefügt wird, sämtliche Informationen über die aufgeweiteten Rasterstrukturen mit den zugeordneten Grauwerten derart überlagert werden, dass eine resultierende Information gebildet wird, die jedem Punkt der Rasterstruktur einen bestimmten Grauwert zuordnet. Damit erhält man ein «elektronisches Kontaktraster», welches einen durch die Form der Grundrasterstruktur, durch die Anzahl der aufgeweiteten Rasterstrukturen und durch die diesen zugeordneten Grauwerte definierten, genau einstellbaren Grauwertverlauf aufweist.

Eine weitere Variante bei der Erzeugung eines «elektronischen Kontaktrasters» besteht darin, sich eine Grundrasterstruktur wie oben beschrieben zu erzeugen und für ein charakteristisches Rasterelement einen Grauwertverlauf mittels der Computergrafik zu definieren, indem z.B. der Grauwert als Funktion der Lagekoordinaten $(x, y)$ eines charakteristischen Rasterelements der Grundrasterstruktur definiert und optisch dargestellt wird. Überträgt man diese Information auf die gesamte Grundstruktur, so erhält man ebenfalls ein «elektronisches Kontaktraster».

Mit diesen Informationen kann wieder ein Laser gesteuert werden, der auf ein unbelichtetes Halbtonmaterial die Rasterstruktur und den definierten Grauwertverlauf belichtet. Dieses als Halbtonmaterial vorliegende Kontaktraster kann dann wie in der klassischen Rastertechnik verwendet werden.

Weiter ist auch eine direkte Aufrasterung eines Halbtonbildmotivs möglich, wobei die Herstellung eines fotografischen Kontaktrasters umgangen wird. Wird z.B. die aufzurasternde Halbtonvorlage derart gescannt, dass für jeden Punkt des Halbtonbildmotivs der dort vorliegende Grauwert gespeichert wird, und überlagert man diese Information mit dem gespeicherten »elektronischen Kontaktraster» derart, dass für jeden Punkt der Halbtonvorlage und des elektronischen Kontaktrasters die Grauwerte addiert werden, wobei eine resultierende Information abgespeichert wird, wenn eine bestimmte, empirisch zu ermittelnde Grauwertschwelle bei dieser Addition überschritten wird, so erhält man über diese resultierende Information ein vollständig aufgerastertes Bildmotiv, welches optisch angezeigt und mittels eines Laserstrahlschreibers auf ein Strichmaterial oder direkt auf eine Druckplatte übertragen werden kann.

Zu den «technisierten» Verfahren ist abschliessend zu sagen, dass sie aufgrund der Verwendung einer grafikfähigen EDV-Anlage und eines Scanners äusserst variabel bei der Erzeugung von Rasterstrukturen und Grauwertverläufen sind, eine sofortige Umsetzung eines Halbtonbildmotivs in eine beliebige Rasterstruktur und die optische Darstellung dieser Aufrasterung auf dem Bildschirm ermöglichen, was bei der Erprobung neuer Rasterformen von nicht zu unterschätzendem Wert ist, da sich unter anderem auch der Zeitaufwand gegenüber den klassischen Verfahren erheblich reduziert. Im folgenden wird anhand der nachstehend aufgeführten Figuren die Erfindung näher erläutert.

Fig. 1 schematische Darstellung des Verfahrensablaufs beim «Einzelstufen-Tonwert-Verfahren»

Fig. 2 Rastergrundstruktur-Positiv (schematisch)

Fig. 3 Rastergrundstruktur-Negativ (schematisch)

Fig. 4a erste aufgeweitete Rasterstruktur-Positiv

Fig. 4b zweite aufgeweitete Rasterstruktur-Positiv

Fig. 5a erste aufgeweitete Rasterstruktur-Negativ

Fig. 5b zweite aufgeweitete Rasterstruktur-Negativ

Fig. 6 aufzurasterndes Halbtonbildmotiv

Fig. 7a erster Tonwertauszug-Negativ

Fig. 7b zweiter Tonwertauszug-Negativ

Fig. 8a erstes Rasterergebnis-Positiv

Fig. 8b zweites Rasterergebnis-Positiv

Fig. 9 aufgerastertes Bildmotiv

Fig. 10 Rasterstrukturstärke als Funktion des Grauwerts der Halbtonvorlage

Fig. 11 Belichtungsanordnung «Einzelstufen-Halbton-Verfahren»

Fig. 12 aufzurasterndes Bildmotiv

Fig. 13 aufgeweitete Rasterstrukturen-Positiv

Fig. 14 Tonwertauszüge

Fig. 15 Rasterergebnisse, Einzelstufen

Fig. 16 aufgerastertes Bildmotiv

Fig. 17 Rastergrundstruktur-Guillochen

Fig. 18 aufgerastertes Bildmotiv

Fig. 19 charakteristische Linienkreuzungen-Guillochen

Fig. 20 «Kontaktraster-Halbton-Verfahren»

Fig. 21 Belichtungsanordnung bei Kontaktrasterherstellung

Fig. 22 Grauwertverlauf im Stufenkontaktraster

Fig. 23 stufenförmige Approximation eines kontinuierlichen Grauwertverlaufs im Kontaktraster

Fig. 24 Grauwertverlauf im Kontaktraster nach unscharfer Belichtung

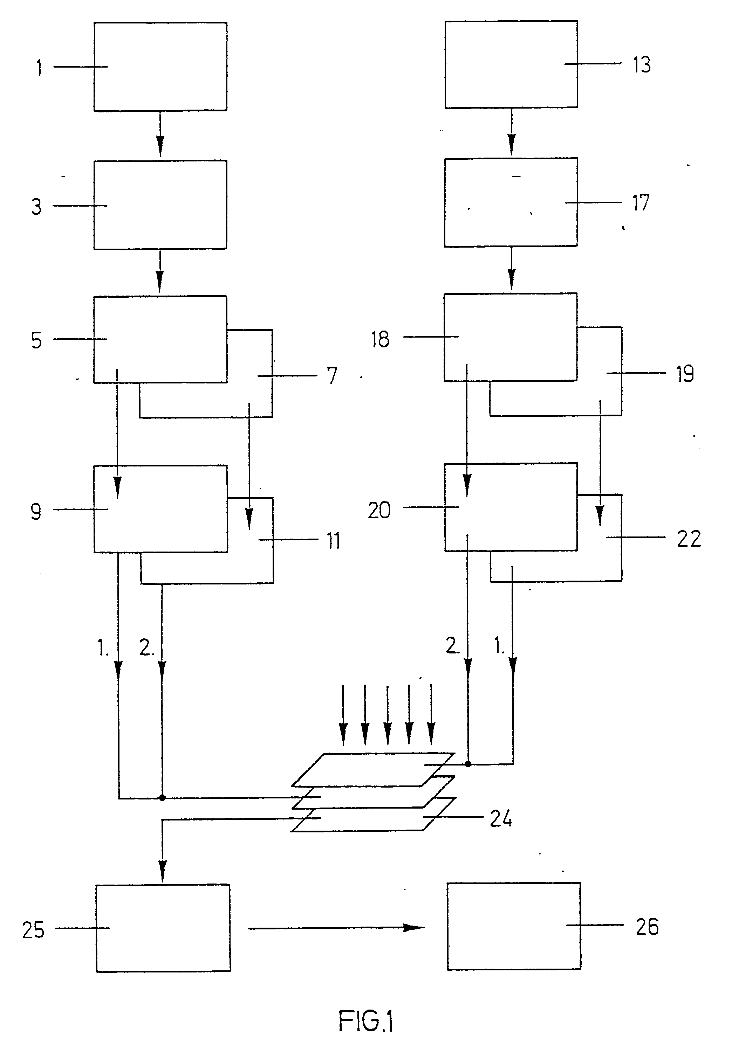

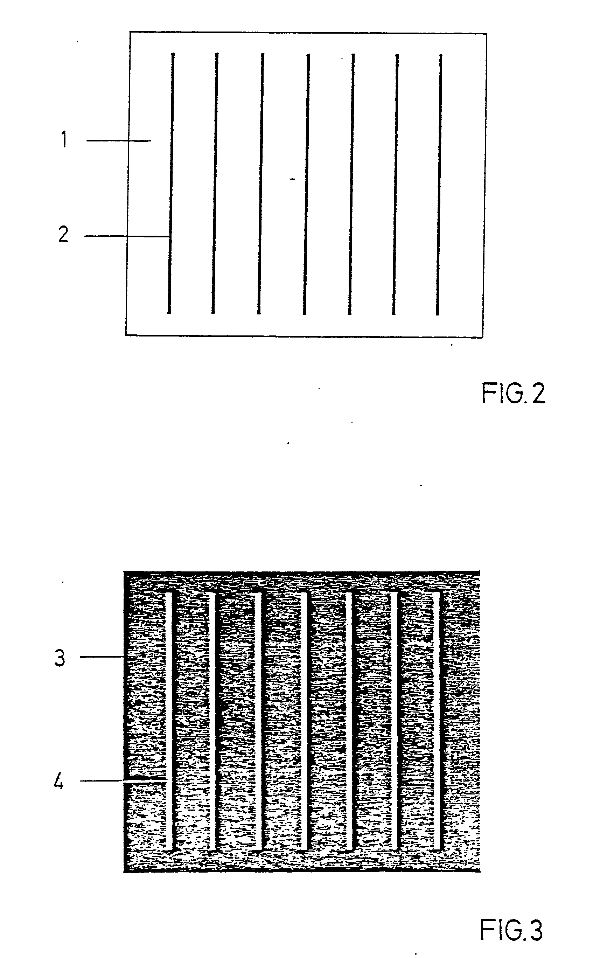

Fig. 1 zeigt einen schematisierten Ablaufplan des «Einzelstufen-Tonwert-Verfahrens» bzw. «EDV-Einzelstufen-Verfahrens», wobei die Einzelschritte anhand der nachfolgenden Fig. 2 bis 9 näher erläutert werden. Zum besseren Verständnis dieser Verfahren wird in den Fig. 2 bis 9 mit stark schematisierten Darstellungen gearbeitet und es werden nur die zum Verständnis wesentlichen Schritte dargestellt. Weiter unten wird anhand der Fig. 12 bis 18 das Verfahren mit realistischeren Rasterstrukturen noch einmal kurz dargestellt, um einen kleinen Eindruck der Anwendungsmöglichkeiten zu geben.

Weiter sei noch angemerkt, dass zuerst immer die fototechnische Verfahrensversion erklärt und anschliessend kurz die «technisierte» Variante skizziert wird, die vom Verfahrensablauf zur fototechnischen Version im wesentlichen analog verläuft. Mögliche Schnittstellen, d.h. Überwechselmöglichkeiten von der fototechnischen zur «technisierten» Variante, werden in der Regel nur kurz angedeutet bzw. nicht explizit erwähnt, da diese Schnittstellen im Prinzip zwischen allen Verfahrensschritten liegen können und somit offensichtlich sind.

Der linke Zweig des Verfahrensablaufplans in Fig. 1 zeigt die Erzeugung von aufgeweiteten Rasterstrukturen aus einer Rastergrundstruktur bzw. Originalrasterstruktur. Von einem Positiv 1 der Rastergrundstruktur – Fig. 2 zeigt ein Positiv 1 einer solchen stark schematisierten Rastergrundstruktur, die durch sieben Streifen 2 einer definierten Strukturstärke symbolisiert wird, wobei die Streifen 2 völlig deckend ist – wird ein Negativfilm 3 (Fig. 3) hergestellt.

Von diesem Negativ 3 werden aufgeweitete Rasterstrukturen 5, 7 als Strichrepros hergestellt (in diesem Fall zwei), indem man das Negativ 3 auf ein unbelichtetes Strichmaterial legt und durch gezielte Steuerung der Belichtung, d.h. gezieltes Überstrahlen, eine Aufweitung der Streifen erzielt.

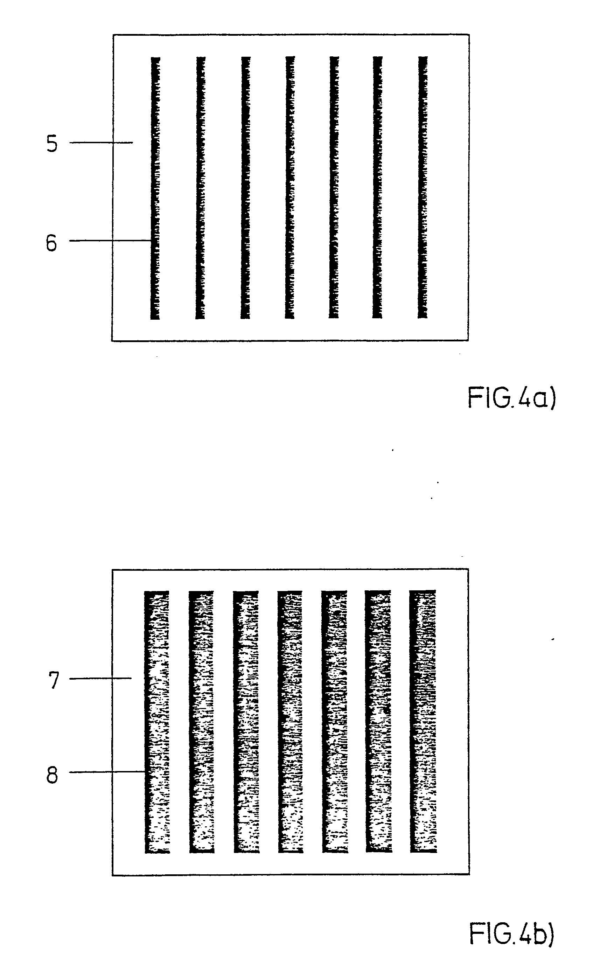

Fig. 4a zeigt das beim ersten Überstrahlungsvorgang entstehende Positiv 5 mit breiter werdenden Streifen 6, d.h. mit einer gegenüber der Rastergrundstruktur angewachsenen Strukturstärke.

Fig. 4b zeigt das beim zweiten Überstrahlungsvorgang entstehende Positiv 7 mit noch stärker aufgeweiteten Streifen 8. Der Grad der Aufweitung ist durch die Belichtungszeit gezielt steuerbar.

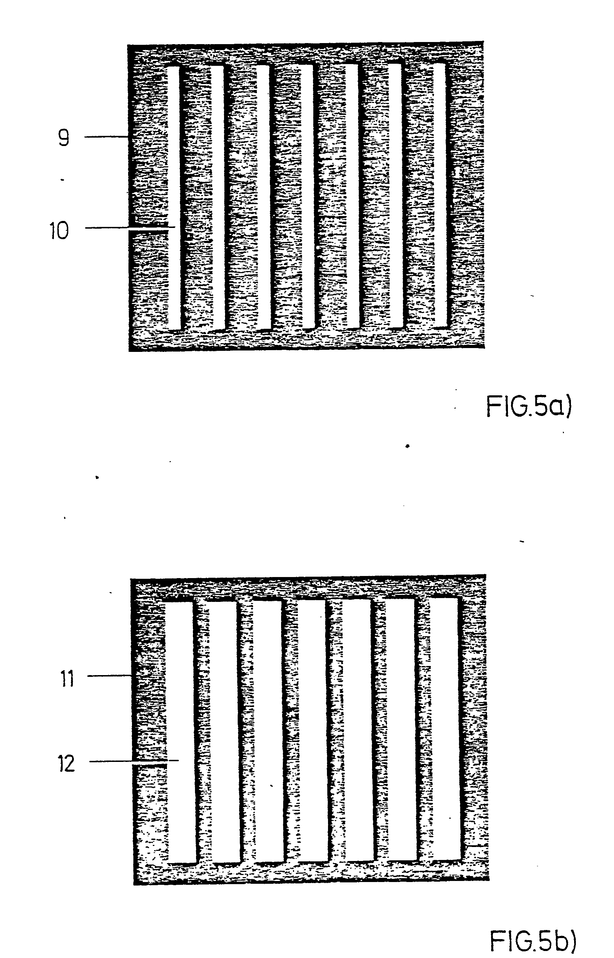

Der nächste Verfahrensschritt in Fig. 1 besteht darin, von diesen als Positivfilm 5, 7 vorliegenden Strichrepros wachsender Strukturstärke Negative 9, 11 herzustellen, welche in Fig. 5a und 5b dargestellt sind.

Der rechte Zweig in Fig. 1 zeigt die Aufbereitung des aufzurasternden Halbtonbildmotivs 13.

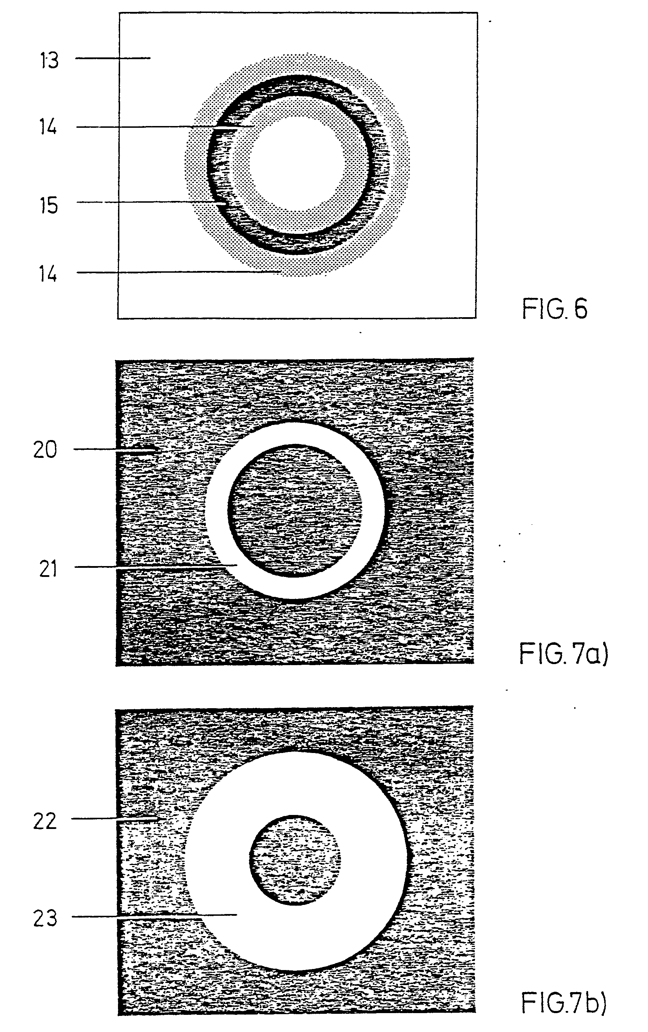

In Fig. 6 ist ein Positiv 13 des aufzurasternden Bildmotivs dargestellt, ein Kreisring mit zwei unterschiedlichen Graustufen 14 und 15, stellvertretend für einen beliebigen, kontinuierlichen Grauwertverlauf des aufzurasternden Halbtonbildmotivs.

Von diesem Positiv 13 des Halbtonbildmotivs (Fig. 1) wird ein Negativfilm 17 hergestellt, von dem dann als Positivfilm 18, 19 vorliegende Tonwertauszüge erstellt werden, indem das Halbtonnegativ 17 für jeden Tonwertauszug auf ein neues unbelichtetes Strichmaterial gelegt und eine bestimmte Zeitspanne belichtet wird. Die Dauer der Belichtung richtet sich danach, welcher Grauwert aus dem Halbtonbildmotiv «ausgezogen» werden soll. In diesem Beispiel wird für den ersten Tonwertauszug die Belichtungszeit so gewählt, dass der schwarze Kreisring 15 aus Fig. 6 «ausgezogen» wird, der Tonwertauszug mit der geringsten Strukturstärke also gerade den dunkelsten Bereich des Halbtonbildmotivs wiedergibt.

Alle Grauwerte des Bildmotivs, beginnend bei weiss bis zu einem bestimmten, geeignet zu wählenden Grauwert werden insgesamt zu weiss aufintegriert und die restlichen Grauwerte zu schwarz, wobei hier (beim ersten Tonwertauszug) der Übergang so gewählt wurde, dass er genau zwischen den Grauwerten der Kreisringe 15 und 14 (Fig. 6) liegt.

Für den zweiten Tonwertauszug wird die Belichtungszeit derart erhöht, dass zusätzlich zum Kreisring 15 (Fig. 1) auch noch der nächste Grauwertbereich, die Kreisringe 14, «ausgezogen» werden, insgesamt also ein grösserer Grauwertumfang des Halbtonbildmotivs durch diesen zweiten Tonwertauszug wiedergegeben wird.

Von diesen als Positivfilm 18, 19 (Fig. 1) vorliegenden Tonwertauszügen werden Negativfilme 20, 22 (Fig. 1) hergestellt, die in Fig. 7a und 7b dargestellt sind.

Fig. 7a zeigt das Negativ des ersten Tonwertauszugs mit der schmalsten Strukturstärke, d.h. den im Halbtonmotiv dunkelsten «ausgezogenen» Bereich, hier der Ring 21, der dem Ring 15 in Fig. 6 entspricht.

Fig. 7b zeigt das Negativ 22 des zweiten Tonwertauszugs grösserer bzw. zunehmender Strukturstärke 23, d.h. den durch die Belichtungszeit bestimmten grösseren, «ausgezogenen» Grauwertbereich, der in diesem Fall aus den Ringen 14, 15 aus Fig. 6 besteht.

Mit den bisherigen Verfahrensschritten ist bereits festgelegt, welche Grauwerte bzw. Grauwertbereiche des Halbtonbildmotivs in welche aufgeweitete Strukturstärke der Rastergrundstruktur umgesetzt werden sollen. Der eigentliche Umsetzungsprozess ist unten in Fig. 1 bei der Vereinigung des linken mit dem rechten Verfahrenszweig dargestellt. Das als Negativfilm vorliegende Strichrepro 9 mit der schmalsten Strukturstärke wird zusammen mit dem als Negativfilm vorliegenden Tonwertauszug 22 mit der grössten Strukturstärke in Kontaktanordnung auf ein unbelichtetes Strichmaterial 24 gelegt. Diese Anordnung wird solange belichtet, bis in den Bereichen des Strichmaterials, wo die Anordnung vollkommen lichtdurchlässig ist, eine vollständige Schwärzung erfolgt ist, so dass der durch den Tonwertauszug 22 bestimmte Grauwertbereich des Halbtonbildmotivs (der Ring 23 in Fig. 7b) durch das Raster mit der schmalsten Strukturstärke wiedergegeben wird.

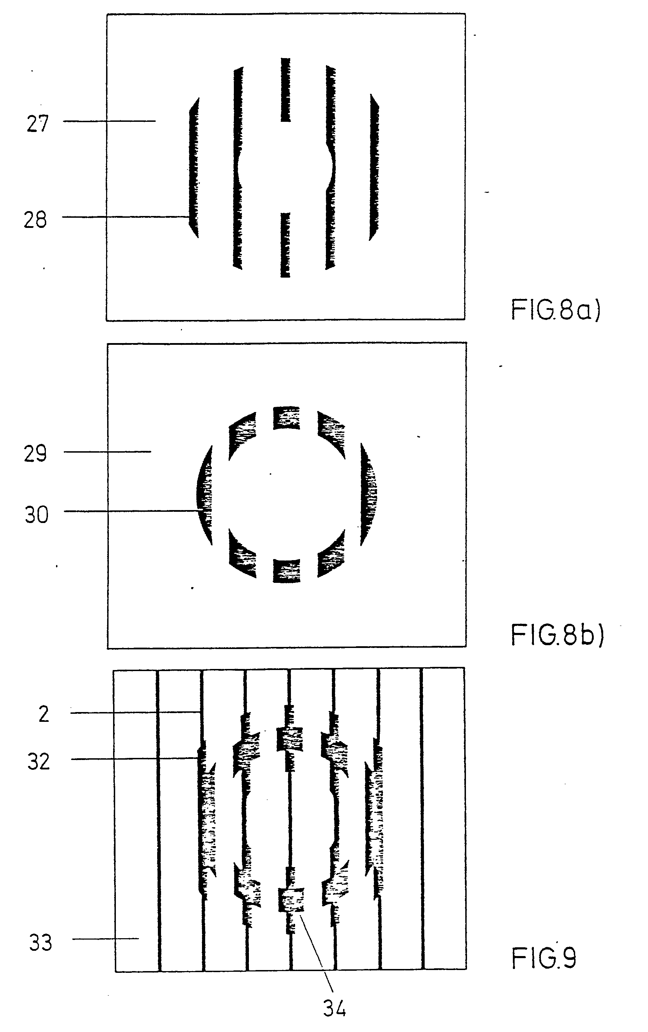

Das Ergebnis dieses Belichtungsvorgangs ist in Fig. 8a dargestellt. Das dort gezeigte Positiv 27 des oben belichteten Strichmaterials 24 gibt die aufgeweitete Rasterstruktur 28 in den Bereichen wieder, wo der Tonwertauszug 22 das Licht vollständig durchlässt, d.h. im Bereich des Ringes 23 auf Fig. 7b.

Mit dem zweiten Tonwertauszug 20 (Fig. 7a) mit der geringeren Strukturstärke und dem diesem zugeordneten Strichrepro 11 (Fig. 5b) geringerer Strukturstärke und einem neuen, unbelichteten Strichmaterial wird analog verfahren.

Das Ergebnis dieses zweiten Belichtungsvorgangs ist in Fig. 8b dargestellt. Anschliessend können die beiden belichteten und entwickelten Strichmaterialien zur vollen aufgerasterten Bildinformation zusammenkopiert werden.

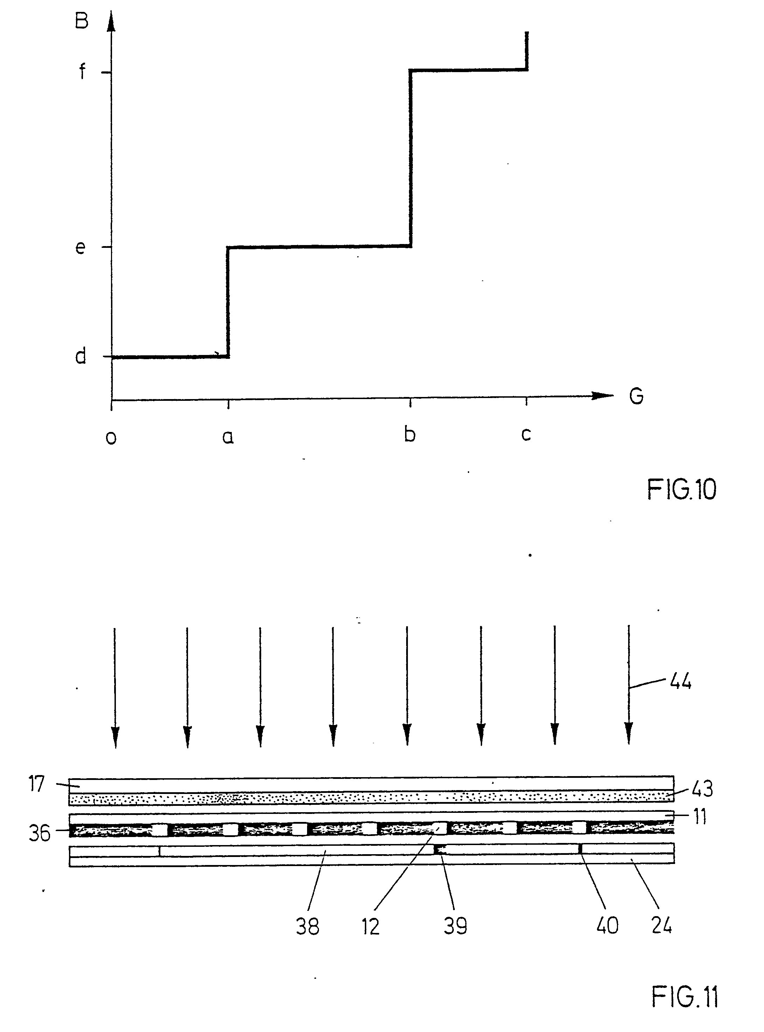

Fig. 9 zeigt das vollständig aufgerasterte Bildmotiv als Positiv 33, wobei noch zusätzlich die Rastergrundstruktur bzw. Originalrasterstruktur 2 (aus Fig. 2) einkopiert wurde. Der dunkelste Grauwertbereich aus dem aufzurasternden Halbtonbildmotiv 13 aus Fig. 6 wird lokal durch die am stärksten aufgeweitete Rasterstruktur 34 wiedergegeben, die helleren Bereiche durch die Rasterstruktur mit der geringeren Strukturstärke 32 Das Einkopieren der Grundrasterstruktur 2 ist besonders vorteilhaft bei der Verwendung von Guillochen als Grundrasterstruktur, da dabei der Linienverlauf in allen Bildpartien ununterbrochen verfolgbar ist, was beim Wertpapierdruck als wichtiges Sicherheitsmerkmal gilt.

Die aufgerasterten Anteile (Fig. 8a und 8b) des Bildmotivs können zur Herstellung von Druckplatten 25 (Fig. 1) verwendet werden, wobei entweder für jeden Anteil (Fig. 8a bzw. 8b) eine separate Druckplatte erstellt wird (z.B. mittels der bekannten kontaktkopiertechnischen Verfahren), so dass die einzeln aufgerasterten Grauwertbereiche des Halbtonbildmotivs auf verschiedenen Druckplatten vorliegen und getrennt verdruckt werden (evtl. wird vorher noch in einen der Anteile die Grundrasterstruktur einkopiert oder für diese eine zweite, zusätzliche Druckplatte erstellt), oder es wird das insgesamt aufgerasterte Bildmotiv aus Fig. 9 auf eine einzelne Druckplatte übertragen und mit bekannten, in der Wertpapierdrucktechnik üblichen Verfahren wie Simultandruck usw. insgesamt verdruckt. Ausserdem können aus der Wertdrucktechnik bekannte, über Farbverlaufstechniken und dergleichen erzielbare optische Effekte verwendet werden sowie auch Farben, die reprotechnisch nicht oder nur sehr schwer zu trennen sind.

Arbeitet man mit mehreren Druckplatten, welche die verschiedenen Grauwertbereiche wiedergeben, so lassen sich damit besondere farbliche, aber auch sicherungstechnisch interessante Effekte erzielen, wenn die einzelnen Druckplatten verschiedene Farben tragen, die passergenau übereinander gedruckt werden, so dass sich im fertig gedruckten Aufzeichnungsträger 26 (Fig. 1) je nach Strukturstärke der Rasterstruktur ein stufenpyramidenartiger Linienquerschnitt ergibt, der aus verschiedenen Farbschichten besteht. Die Verwendung metallischer, metamerer, thermo- oder fotochromer Farben für eine oder mehrere dieser Farbschichten bildet ein besonders wertvolles Sicherheitsmerkmal, da dieses in die Bildstruktur gezielt eingebracht wird und sozusagen einen Teil der Bildinformation darstellt.

Die hier erwähnten drucktechnischen Möglichkeiten gelten auch für sämtliche im folgenden geschilderten Verfahren, und es wird daher nicht mehr besonders auf sie eingegangen.

Anhand von Fig. 10 wird die Umsetzung des kontinuierlichen Grauwertverlaufs einer Halbtonvorlage in eine stufenweise aufgeweitete Rasterstruktur näher erläutert. Und zwar ist das Diagramm so zu interpretieren, dass die auf der Achse G aufgetragene kontinuierliche Grauwertskala in bestimmte Strukturstärke B der Rasterstruktur umgesetzt wird, d.h. das Diagramm zeigt die Strukturstärke B als Funktion des Grauwerts G der Halbtonvorlage. Sämtliche Grauwerte von 0 bis zum Wert a werden durch die einkopierte Originalrasterstrukturbreite d wiedergegeben, die Werte von a bis d durch die Breite e und die Werte von b bis c durch die Breite f. Geht man von einem Halbtonnegativ des Bildmotivs mit kontinuierlichem Grauwertverlauf aus, so können z.B. am Punkt a geringe statistische Schwankungen im Lichteinfall zu unregelmässigen, nicht kontrollierbaren Schwankungen zwischen den beiden Rasterbreiten e und d führen, was die Qualität des optischen Eindrucks des aufgerasterten Bildmotivs beeinträchtigen kann. Mit den Tonwertauszügen ist man nun in der Lage, die Grenzen, bis zu denen die Grauwerte der Vorlage zu schwarz aufintegriert werden, so einzustellen, dass man sich genau unterhalb des Sprungbereichs von Rasterbreite d zu e befindet und diese Schwankungserscheinungen irrelevant werden. Natürlich ist es bei diesen Verfahren auch möglich, jede beliebige Einstellung der Grenzen zu wählen und damit die Grauwertwiedergabe durch eine bestimmte Strukturstärke bzw. Aufweitung der Rastergrundstruktur exakt zu steuern. Man kann auch mit beliebig vielen, im Rahmen der technischen Möglichkeiten herstellbaren Rasterstufen arbeiten und einen quasikontinuierlichen bis kontinuierlichen Verlauf erreichen. Der besondere Vorteil dieses Verfahrens besteht darin, dass man frei wählbare unabhängige Parameter hat, die sich bei jedem Verfahrensschritt exakt und jederzeit kontrollierbar aufeinander abstimmen lassen.

Bevor auf das dem «Einzelstufen-Tonwert-Verfahren» entsprechende «EDV-Einzelstufen-Verfahren» näher eingegangen wird, seien zuerst noch weitere fototechnische Varianten des Einzelstufenverfahrens kurz dargestellt. Anstatt, wie oben erläutert, die Belichtungsvorgänge mit den Paaren: Strichrepro des Rasters – zugeordneter Tonwertauszug auf jeweils ein neues Strichmaterial 24 vorzunehmen, ist es auch möglich, sämtliche Belichtungsvorgänge auf dasselbe Strichmaterial 24 durchzuführen, so dass das Zusammenkopieren der einzelnen aufgerasterten Anteile umgangen wird.

Ausserdem ist auch die Reihenfolge der Belichtungsvorgänge beliebig, was für sämtliche fototechnischen Verfahren gilt.

Eine weitere fototechnische Variante ist das «Einzelstufen-Halbton-Verfahren», das prinzipiell genauso wie das «Einzelstufen-Tonwert-Verfahren» verläuft. Abweichend von diesem werden jedoch vom aufzurasternden Bildmotiv keine Tonwertauszüge erstellt, sondern es wird anstelle der Tonwertauszüge 18, 19 bzw. 20, 22 (Fig. 1) mit dem Negativfilm 17 des Halbtonbildmotivs gearbeitet. Der aus diesem Halbtonbildmotiv in die diesem jeweils zugeordnete Strukturstärke umzusetzende Grauwertbereich wird beim Belichtungsvorgang mit den stufenweise aufgeweiteten Rasterstrukturen 9, 11 durch die Belichtungszeit festgelegt. Dunkle Grauwerte des aufzurasternden Halbtonpositivs werden durch kurze, helle Grauwerte durch längere Belichtungszeiten in die jedem Bereich zugeordnete, aufgeweitete Rasterstruktur umgesetzt. Im obigem Beispiel wird also das Strichrepro 9 (Fig. 5a) der geringsten Strukturstärke zusammen mit dem Halbtonnegativ 17 des aufzurasternden Bildmotivs in Kontaktanordnung auf ein unbelichtetes Strichmaterial 24 gelegt und so lange belichtet, bis die dunklen Grauwerte des Halbtonpositivs durch die Rasterstrukturstärke des Strichrepros 9 wiedergegeben werden, wobei durch die Belichtungsdauer die Grenze dieses Grauwertbereichs gezielt festgelegt werden kann. Mit dem folgenden Strichrepro 11 (Fig. 5b) wachsender Strukturstärke und demselben Halbtonnegativ 17 wird analog verfahren, nur dass die Belichtungszeit entsprechend dem umzusetzenden Grauwertbereich vergrössert wird.

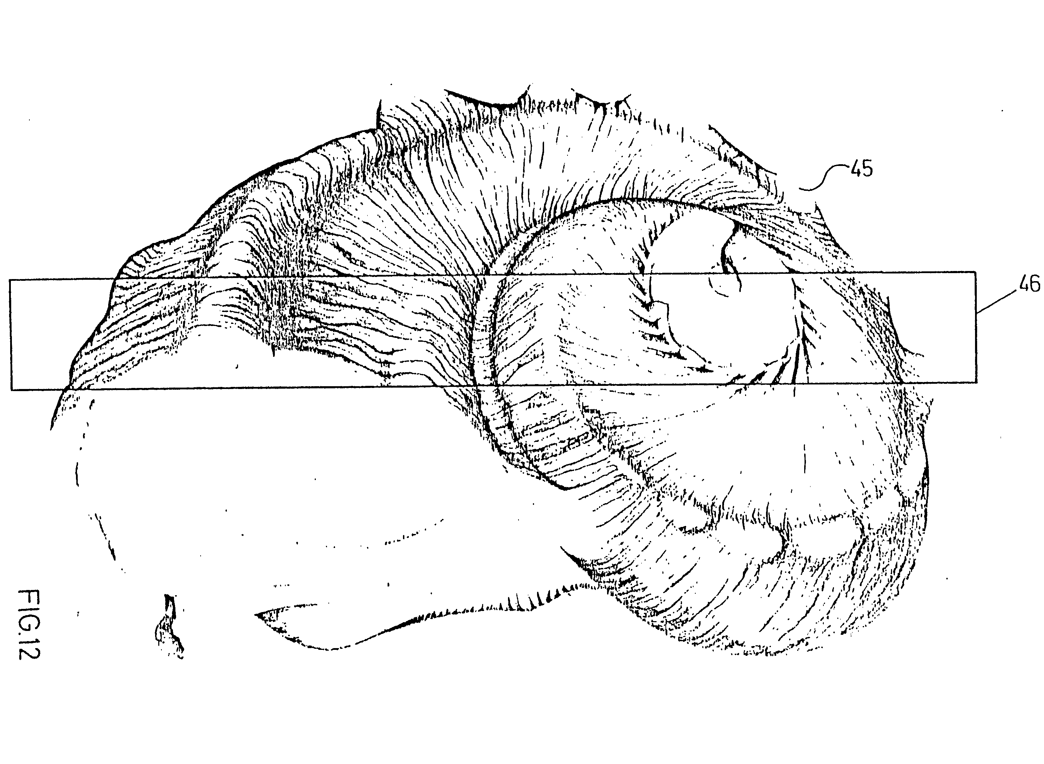

Fig. 11 zeigt die schematische Belichtungsanordnung beim «Einzelstufen-Halbton-Verfahren», wobei in dem hier dargestellten Beispiel sämtliche Belichtungsvorgänge auf ein einziges Strichmaterial erfolgen und die Belichtungszeiten in diesem Fall etwas anders gewählt werden müssen als beim «Einzelstufen-Halbton-Verfahren», bei dem für jede aufgeweitete Rasterstruktur ein neues Strichmaterial verwendet wird. Das Halbtonnegativ 17 des aufzurasternden Bildmotivs mit seinen unterschiedlichen, die Bildinformation wiedergebenden Grauwerten in der Fotoemulsionsschicht 43, wird in Kontakt mit einem als Negativfilm 11 vorliegenden Strichrepro der aufgeweiteten Rastergrundstruktur, das im Bereich der Rasterstruktur 12 vollkommen lichtdurchlässig ist, auf ein Strichmaterial 24 gelegt und mit parallelem Licht 44 eine genau definierte Zeitspanne lang belichtet. Dieser Belichtungsvorgang des Strichmaterials wird mit jeder aufgeweiteten Rasterstruktur wiederholt. Im Bereich der Rasterfenster 12 wird je nach Lichteinfall das Strichmaterial geschwärzt. In diesem Fall ist z.B. der Belichtungsvorgang mit der zweiten aufgeweiteten Rasterstruktur aus Fig. 5b dargestellt. Im Bereich 39 fällt so viel Licht durch das Rasterfenster 12, um eine vollständige Schwärzung zu bewirken, während im Bereich 40 die Lichtmenge gerade ausreicht, aufgrund der kumulativen Wirkung des Lichteinfalls in der fotoempfindlichen Schicht des Strichmaterials den schon im ersten Belichtungsvorgang mit der schmalsten Rasterstrukturstärke zwar belichteten, aber dort noch nicht vollständig geschwärzten Bereich, die fast digitale Gradationsschwelle des Strichmaterials überschreiten zu lassen und eine Schwärzung zu bewirken. Dabei erstreckt sich die Schwärzung über den von beiden Rastern freigelassenen Bereich, d.h. also hier nur über die Rasterweite des schmalsten Rasters; der vom zweiten Raster darüberhinaus freigelassene Bereich wird hier noch nicht geschwärzt, da die Gesamtlichtmenge dazu noch nicht ausgereicht hat. Würde man noch mit weiteren, aufgeweiteten Rasterstrukturen arbeiten, so würde dieser Belichtungsvorgang mit jeder aufgeweiteten Rasterstruktur analog durchgeführt, wobei die jeweiligen Belichtungszeiten sich genau einstellen lassen, um die erwünschte Halbtonumsetzung des Bildmotivs in schmaler oder breiter werdende Rasterstrukturen zu erzielen.

Die Herstellung von Druckplatten und der Druck des Aufzeichnungsträgers verläuft analog zum «Einzelstufen-Tonwert-Verfahren». Für das «EDV-Einzelstufen-Verfahren» gilt prinzipiell der gleiche Verfahrensablauf wie in Fig. 1 dargestellt. Des

besseren Verständnisses wegen und zur Hervorhebung der möglichen Schnittstellen zwischen fototechnischen und «technisierten» Verfahren wird der Ablauf dieses Verfahrens in die Abschnitte

1. Erzeugung der Rastergrundstruktur

2. Erzeugung der aufgeweiteten Rasterstrukturen

3. Erzeugung der «Tonwertauszüge»

4. Aufrasterungsprozess

aufgeteilt. Hinter jeden der Abschnitte 1. bis 4. kann praktisch zum fototechnischen Verfahren «übergewechselt» bzw. vom fototechnischen Verfahren in das «technisierte» Verfahren gesprungen werden.

Die technischen Apparaturen für die «technisierten» Verfahren bestehen aus einer EDV-Anlage mit einem grafikfähigen Terminal, einer mit der EDV-Anlage verbundenen Scanning-Einrichtung und einem durch die EDV-Anlage gesteuerten Laserstrahlschreiber.

1. Abschnitt: Erzeugung der Rastergrundstruktur. Die Rastergrundstruktur kann mittels computergrafischer Techniken ("Light-Pen", etc.) oder durch spezielle mathematische Programme erzeugt werden (z.B. wenn eine Rasterstruktur aus mathematisch darstellbaren Linienstrukturen oder anderen geometrischen Strukturen wie Kreisen, Dreiecken usw. aufgebaut wird). Diese Rasterstruktur wird separat gespeichert, so dass Form und Lage jedes Rasterelements eindeutig bestimmt sind (z.B. indem jedem Punkt der Rastergrundstruktur eine Information zugeordnet wird, die Auskunft darüber gibt, ob an diesem Punkt Rasterstruktur vorliegt oder nicht).

An dieser Stelle ist bereits ein Übergang zum fototechnischen Verfahren möglich, indem mit den über die Form der Rasterstruktur gespeicherten Informationen der Laserstrahlscheiber gesteuert wird, der die Rastergrundstruktur auf ein Strichmaterial belichtet.

Die Rastergrundstruktur kann aber auch auf fototechnischem oder grafischem Weg erzeugt, dann über die mit der EDV-Anlage verbundene Scanning-Einrichtung nach Lage und Form der Rasterelemente gescannt und die dabei gewonnenen Informationen über die Rastergrundstruktur gespeichert werden.

2. Erzeugung der aufgeweiteten Rasterstrukturen: Die aufgeweiteten Rasterstrukturen können über die EDV-Anlage aus der gespeicherten Rastergrundstruktur erzeugt werden, indem für jede aufgeweitete Rasterstruktur ein «Aufweitungsfaktor» definiert wird, die Rasterelemente um diesen Faktor aufgeweitet werden und die Form jeder aufgeweiteten Rasterstruktur separat gespeichert wird (Schnittstelle zum fototechnischen Verfahren durch Übertragen der aufgeweiteten Rasterstrukturen auf Strichmaterial mittels des EDV-gesteuerten Lasers). Natürlich können auch fotografisch oder grafisch erstellte aufgeweitete Rasterstrukturen gescannt und deren Forminformationen separat gespeichert werden.

3. «Tonwertauszüge»:

Die «Tonwertauszüge» werden gleichfalls über die Scanning-Einrichtung gewonnen, indem über die EDV Grauwertbereiche definiert werden, das Halbtonmotiv für jeden dieser Grauwertbereiche gescannt wird und die Anteile des Halbtonbildmotivs, welche einen Grauwert aus einem dieser Bereiche aufweisen, für jeden Grauwertbereich separat gespeichert werden und gewissermassen in Form «elektronischer Tonwertauszüge» vorliegen (Alternative: Scanning von fotografischen Tonwertauszügen und separate Speicherung dieser Informationen). Der Vorteil der technisierten Variante bei den «elektronischen Tonwertauszügen» liegt darin, dass problemlos und schnell beliebige Grauwertbereiche definiert und ausgezogen werden können.

4. Aufrasterungsprozess:

Der eigentliche Aufrasterungsprozess geschieht derart, dass über die EDV jedem oder nur ausgewählten Grauwertbereichen eine bestimmte, aufgeweitete Rasterstruktur zugeordnet wird, der «elektronische Tonwertauszug», welcher die betreffenden Grauwertanteile des Halbtonmotivs wiedergibt, der zugeordneten aufgeweiteten Rasterstruktur derart überlagert wird, dass die gespeicherte Information über «Tonwertauszug» und zugeordneter Rasterstruktur punktweise miteinander verglichen wird und dann, wenn an einem Punkt Tonwertanteil und Rasteranteil vorliegen, eine resultierende Information gebildet und gespeichert wird, die aussagt, dass an diesem Punkt ein aufgerasterter Bildanteil vorliegt. Dieses Verfahren wird für jedes Paar: Grauwertbereich – zugeordneter «Tonwertauszug» durchgeführt und die Informationen werden für jedes Paar separat gespeichert, so dass als Ergebnis die einzelnen, durch die zugeordnete Rasterstruktur wiedergegebenen Grauwertbereiche des Halbtonbildmotivs in aufgerasterter Form separat gespeichert vorliegen und z.B. auch optisch auf dem Bildschirm dargestellt werden können.

Weiter können die einzelnen aufgerasterten, einen der ausgewählten Grauwertbereiche des Halbtonbildmotivs wiedergebenden Anteile über den EDV-gesteuerten Laser auf verschiedene oder ein einziges Strichmaterial oder auch direkt auf verschiedene oder eine einzige Druckplatte übertragen werden. Es ist natürlich auch möglich, die einzelnen aufgerasterten Anteile in der EDV zum vollständig aufgerasterten Bildmotiv zu überlagern, das fertig aufgerasterte Bildmotiv optisch anzuzeigen, zusätzlich die Rasterstruktur zu überlagern und über den EDV-gesteuerten Laser beliebige Überlagerungen der einzelnen, aufgerasterten Anteile auf eine oder mehrere Druckplatten (oder auch Strichmaterialien) zu übertragen.

Die Variationsmöglichkeiten sind bei diesem Verfahren praktisch unbegrenzt, da aufgrund der Schnelligkeit der EDV Rasterstrukturen, Grauwertbereiche, Aufweitungen, Überlagerungen von aufgerasterten Anteilen an fast jeder Stelle des Verfahrens geändert und die Ergebnisse direkt angezeigt werden können, so dass man die Auswirkung geringer Veränderungen von beliebigen Parametern auf das Endergebnis des Aufrasterungsprozesses sofort beobachten kann.

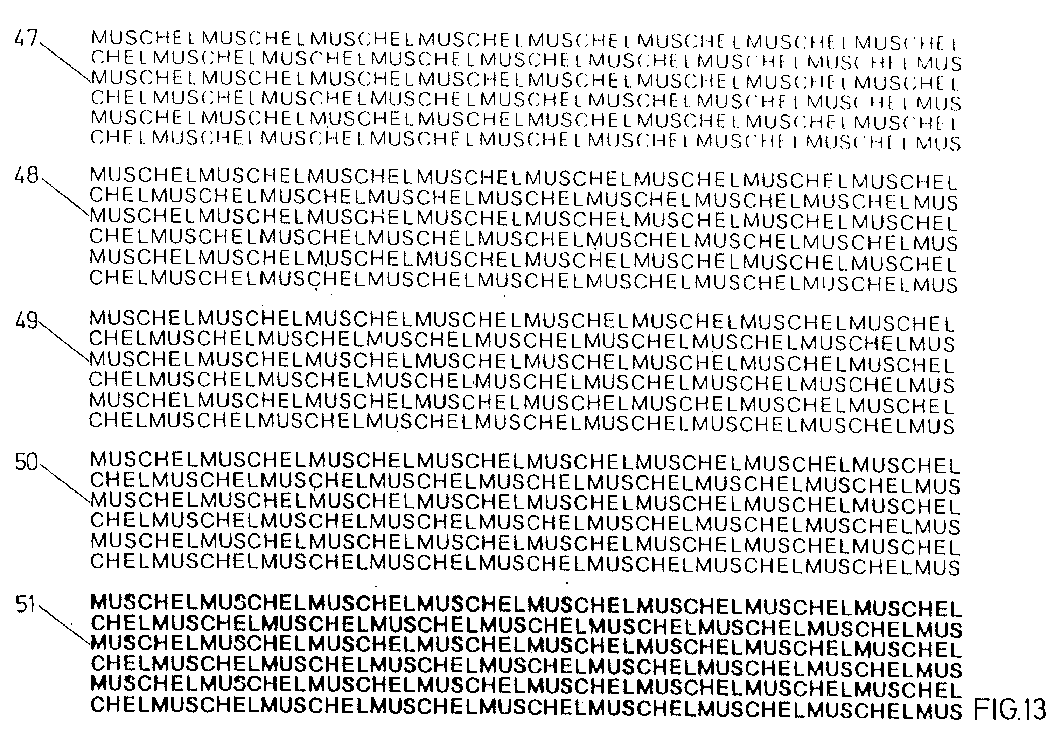

Ein Beispiel, welches die Gestaltungsmöglichkeiten besser herausstellt als die nur schematischen Skizzen in Fig. 2 bis 9, ist in den Fig. 13 bis 16 dargestellt. Der besseren Anschaulichkeit halber wird hier mit Positiven gearbeitet, was natürlich dem Arbeiten mit Negativen äquivalent ist.

Fig. 12 zeigt eine Muschel 45 als aufzurasterndes Halbtonbildmotiv, wobei die folgenden Verfahrensschritte anhand des eingezeichneten Ausschnittfensters 46 näher erläutert werden.

Als Raster wird der in Fig. 13 dargestellte Schriftuntergrund (hier etwas vergrössert dargestellt) benutzt, wobei der Streifen 47 die Grundrasterstruktur bzw. Originalrasterstruktur zeigt und die folgenden Streifen 48, 49, 50, 51 jeweils stufenweise um eine bestimmte Stärke aufgeweitet sind.

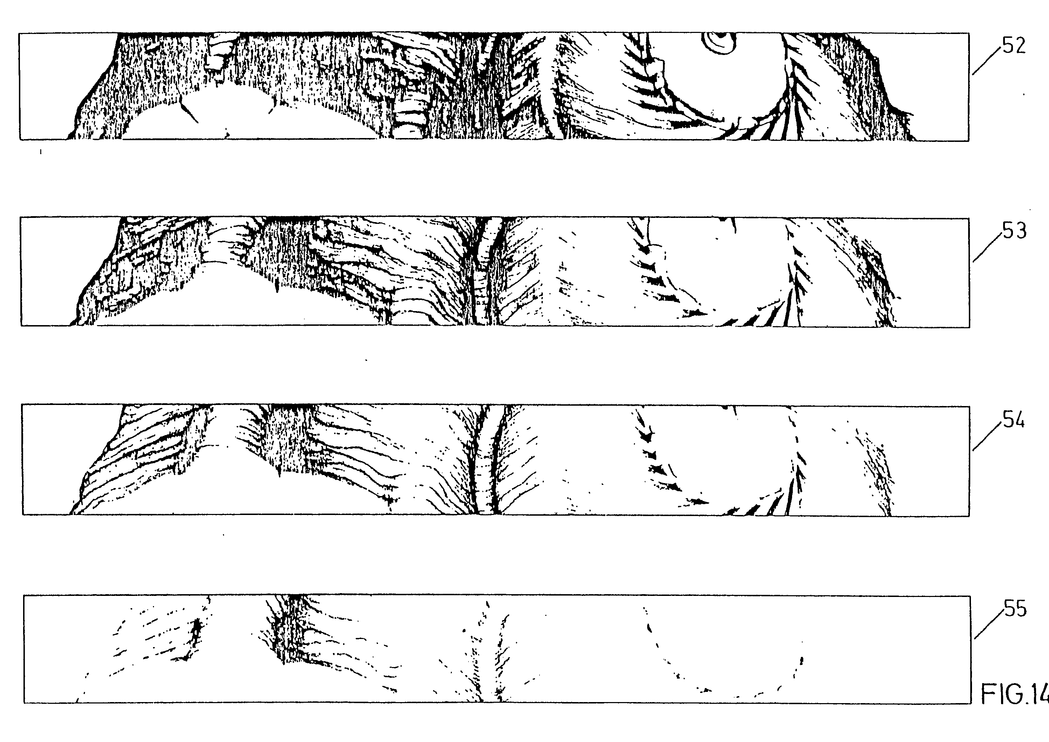

Fig. 14 zeigt vier Tonwertauszüge (52, 53, 54, 55) des Halbtonbildmotivs (Ausschnittfenster 46 aus Fig. 12) mit wachsender Strukturstärke.

Der Tonwertauszug mit der grössten Strukturstärke 52 aus Fig. 14 wird in Kontakt mit der aufgeweiteten Rasterstruktur 48 der schmalsten Strukturstärke (Fig. 13) auf ein Strichmaterial gelegt und solange belichtet, bis das Strichmaterial im nicht von den Buchstaben oder dem Bildmotiv abgedeckten Bereich vollständig geschwärzt ist.

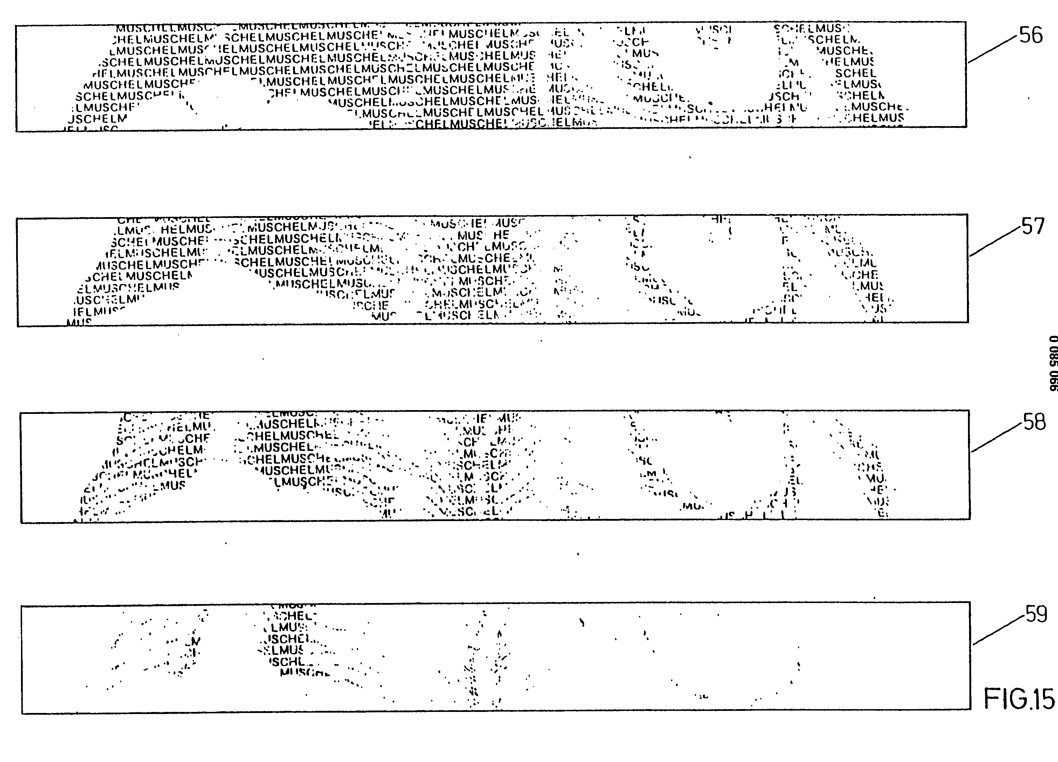

Das Ergebnis dieses Belichtungsvorgangs ist als Positiv 56 in Fig. 15 dargestellt. Mit den weiteren Tonwertauszügen 53, 54, 55 aus Fig. 14, und zwar mit abnehmender Strukturstärke, und den Rasterpositiven 49, 50, 51 aus Fig. 13 mit jeweils wachsender Strukturstärke und einem neuen Strichmaterial wird dann ebenso verfahren.

Die so gewonnenen aufgerasterten Tonwertauszüge 56, 57, 58, 59 sind in Fig. 15 dargestellt, wobei jeder aufgerasterte Tonwertauszug die Anteile des Halbtonbildmotivs, welche Grauwerte aus dem durch den Tonwertauszug bestimmten Grauwertbereich aufweisen, lokal durch die dem betreffenden Tonwertauszug zugeordnete Rasterstrukturstärke wiedergibt. Diese Positive werden zusammenkopiert und anschliessend wird zusätzlich die Grundrasterstruktur 47 auf Fig. 13 einkopiert.

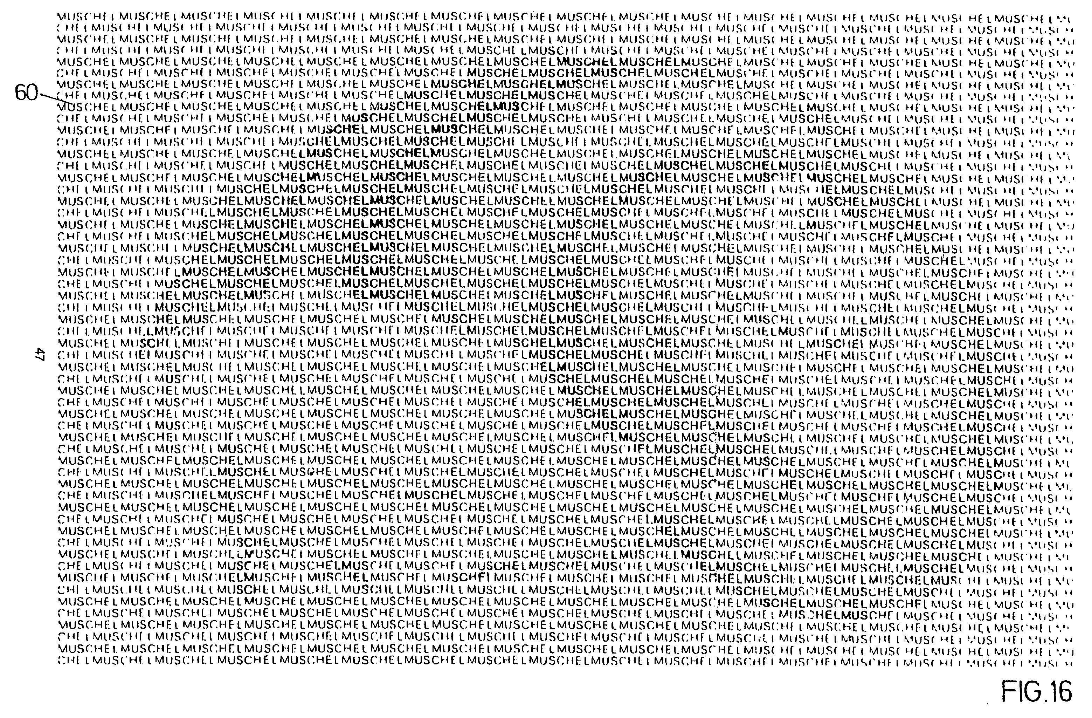

Fig. 16 zeigt das so gewonnene Bildmotiv, das als Druckvorlage oder für andere Zwecke verwendbar ist.

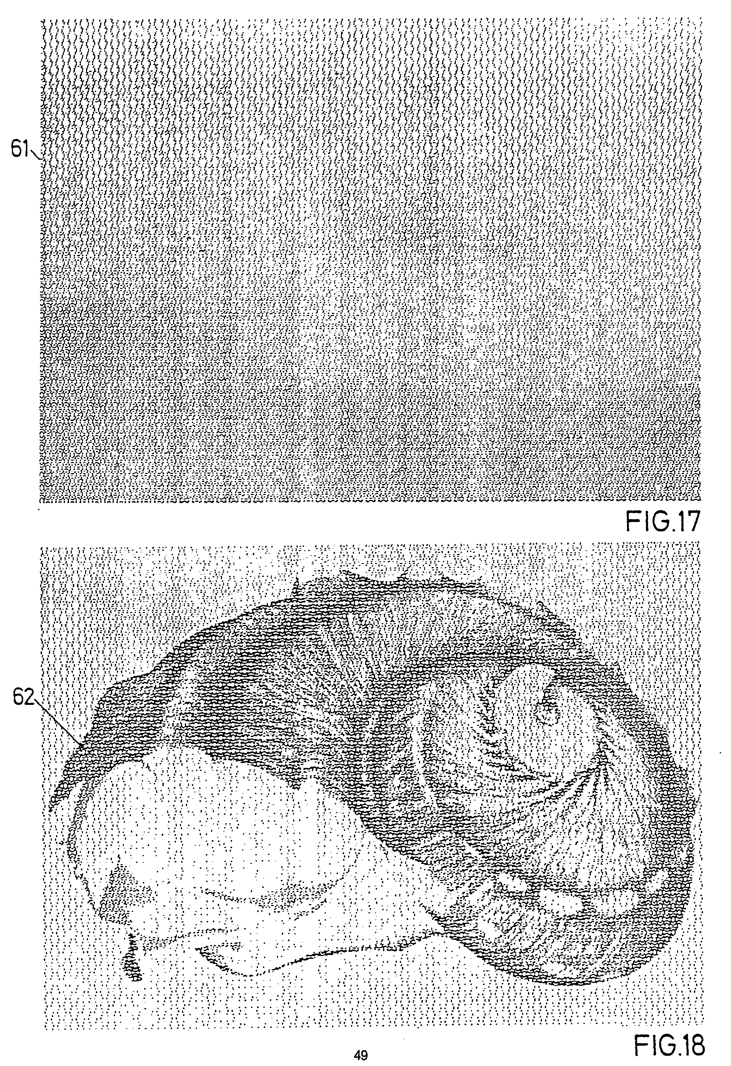

Ein weiteres Anwendungsbeispiel des Einzelstufenverfahrens zeigen die Fig. 17 und 18. Als Rastergrundstruktur dient das in Fig. 17 dargestellte verschlungene Linienmuster 61. Führt man mit diesem Raster die oben beschriebenen Verfahrensschritte durch, erhält man das in Fig. 18 dargestellte aufgerasterte Bildmotiv. Die Bildinformation der Muschel 62 wird hier durch sich verdickende oder verjüngende Linien der Rasterstruktur erzeugt, die jeweils die entsprechenden Grauwertbereiche der Vorlage wiedergeben.

Das bei diesem Beispiel verwendete Linienmuster aus sich verschlingenden und mehrfach kreuzender Linien (ein Beispiel für ein einfaches Guillochenmuster) bringt die besonderen Vorteile dieses Verfahrens für den Banknoten- und Wertpapierdruck erst richtig zur Geltung, da sich in diesem Fall die Wiedergabe einer Bildinformation durch Verdickungen oder Verdünnungen der Linienstruktur so steuern lässt, dass es sich in den dunkelsten Bereichen und in den engsten Maschen zu keinerlei Verklecksungen oder Zusammenschlüssen der Linien kommt, so dass die Linien des Guillochenmusters in allen Teilen des Bildmotivs ununterbrochen verfolgbar sind.

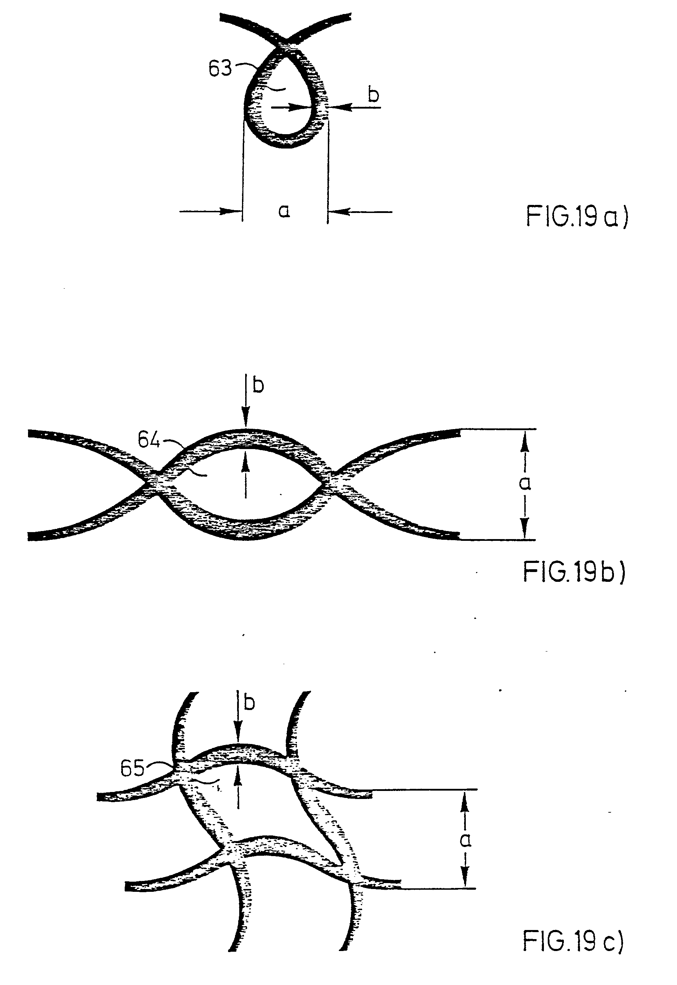

In Fig. 19a bis c sind einige mögliche Maschenformen dargestellt, die bei Sicherheitslinienmustern mit Verschlingungen und Mehrfachkreuzungen der Linien auftreten können.

Fig. 19a zeigt eine Masche 63, die von einer einzelnen Linie gebildet wird, während Fig. 19b eine aus zwei Linien gebildete Masche 64 und Fig. 19c eine aus vier Linie gebildete Masche 65 zeigt. Die Linienbreite b und Maschenweite a sind so aufeinander abgestimmt, dass die Linienbreite b immer weniger als die Hälfte der Maschenweite a beträgt und damit Verklecksungen oder zusammenschliessende Linien in jedem Fall vermieden werden.

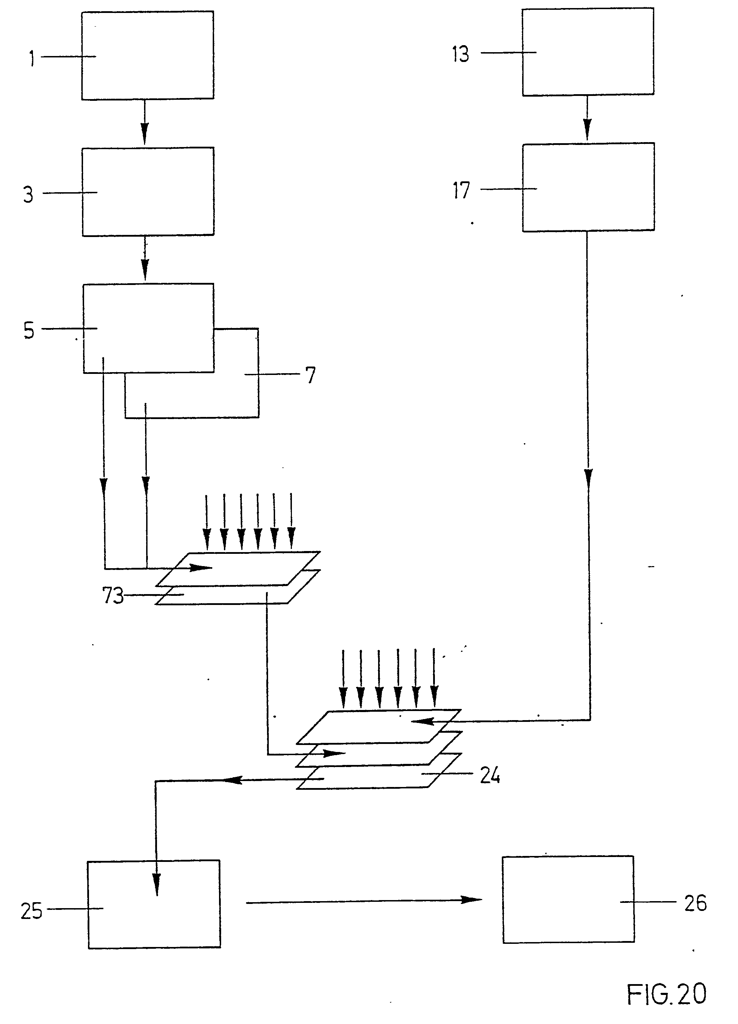

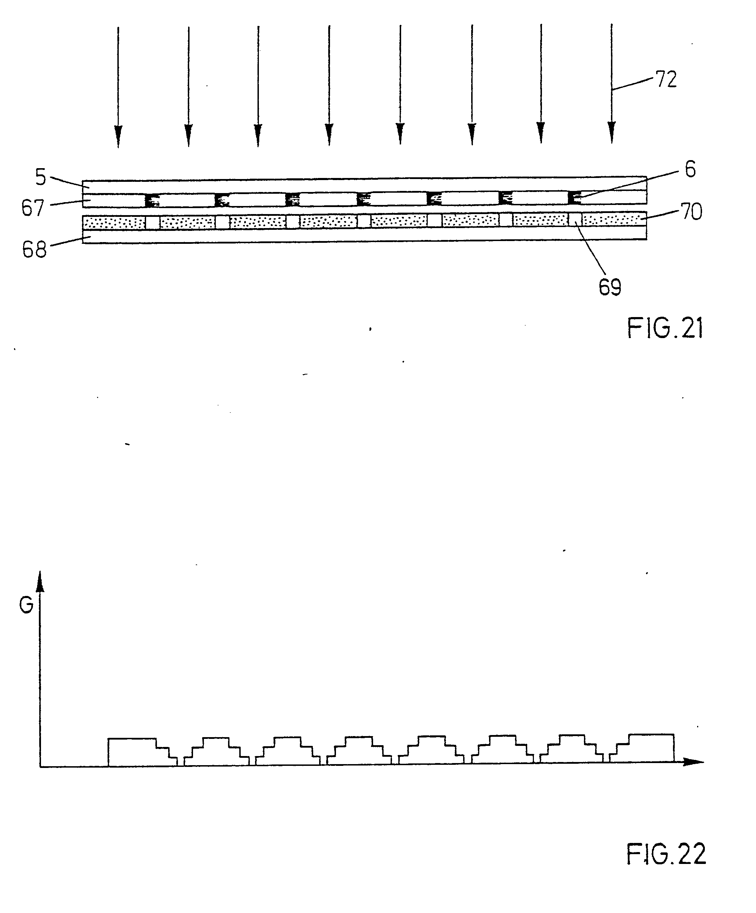

In Fig. 20 ist ein schematischer Verfahrensablaufplan für das fototechnische «Kontaktraster-Halbton-Verfahren» abgebildet, wobei auf dieselben schematischen Figuren (Fig. 1 bis 6, Fig. 9) verwiesen wird wie beim «Einzelstufen-Halbton-Verfahren». Der linke Zweig des Ablaufplans (Fig. 20) zeigt den Herstellungsweg des Kontaktrasters. Von dem Positiv 1 der Grundrasterstruktur (Fig. 1) wird ein Negativ 3 (Fig. 3) hergestellt. Von diesem werden, wie schon beim Einzelstufenverfahren, durch gezieltes Überstrahlen Strichrepros 5, 7 stufenweise (in diesem Fall zwei Stufen) aufgeweitete Rasterstrukturen als Positivfilm hergestellt. Die Anfertigung des Kontaktrasters geschieht derart, dass das Strichrepro 5 mit der schmalsten Strukturstärke 6 auf ein geeignetes, unbelichtetes Halbtonmaterial gelegt und eine bestimmte Zeitspanne lang belichtet wird. Diese Belichtungsanordnung ist in Fig. 21 noch einmal dargestellt. Das Strichrepro 5 (Fig. 4a) mit der in der Fotoemulsionsschicht 67 fixierten geringsten Rasterstrukturstärke 6 wird in direktem Kontakt auf ein Halbtonmaterial 68 mit seiner unbelichteten Fotoemulsionsschicht 70 gelegt und mit parallelem Licht 72 eine genau definierte Zeitspanne lang belichtet. Während des Belichtungsvorgangs bleibt die von der Rasterstruktur 6 bedeckte Fläche 69 von der Belichtung ausgespart und es wird nur die restliche Fläche belichtet, die damit einen bestimmten, durch die Belichtungszeit genau einstellbaren Grauwert bzw. Schwärzung erhält.

Als nächstes wird der analoge Belichtungsvorgang mit dem zweiten Strichrepro 7 (Fig. 20), welches die nächsthöhere Strukturstärke 8 (Fig. 4b) aufweist und demselben, bereits belichteten Halbtonmaterial 68 (Fig. 21) durchgeführt, wobei auf die passgenaue Positionierung von Rasterpositiv 5 und Halbtonmaterial 68 zu achten ist. Dabei erhöht sich die Schwärzung bzw. der Grauwert in der Fotoemulsionsschicht 70 des Halbtonmaterials 68 in dem durch die zweite, stärker aufgeweitete Rasterstruktur 6 (auch Fig. 4b) nicht abgedeckten Bereich, so dass insgesamt mit der ersten Belichtung eine zweite Grau- bzw. Schwärzungsstufe entsteht.

In Fig. 22 ist der stufenförmige Grauwert bzw. Schwärzungsverlauf eines Kontaktrasters dargestellt, wie man ihn mit drei Stufen, d.h. drei aufgeweiteten Rasterstrukturen erhalten würde (in dieser Darstellung wurde als erste Stufe das Positiv der Grundrasterstruktur aus Fig. 2 verwendet). Die Stufenbreite, d.h. Breite der Schwärzungs- bzw. Grauwertstufen ist jeweils durch die Strukturstärke, d.h. hier Breite, der verwendeten aufgeweiteten Rasterstruktur bestimmt und die Stufenhöhe, d.h. der Sprung im Grauwert- bzw. Schwärzungsverlauf, durch die jeweilige, beliebig wählbare und genau einstellbare Belichtungszeit.

Mit einem derartig hergestellten Kontaktraster 73 (Fig. 20) wird dann das aufzurasternde Halbtonbildmotiv 13 (Fig. 20), von dem erst noch ein Negativfilm 17 erstellt wurde, in klassischer Weise aufgerastert, indem Negativfilm 17 des Bildmotivs und Kontaktraster 73 in Kontaktanordnung auf ein unbelichtetes Strichmaterial 24 gelegt und solange belichtet werden, bis die verschiedenen Grauwerte des Halbtonbildmotivs lokal durch die unterschiedlichen, diesem Grauwert zugeordneten Strukturstärken der aufgeweiteten Rasterstrukturen wiedergegeben werden.

Welcher Grauwertbereich der Halbtonvorlage durch welche Strukturstärke wiedergegeben wird, hängt von der Stufenzahl und Stufenhöhe im Kontaktraster und der Belichtungszeit beim Aufrasterungsprozess ab und lässt sich gezielt steuern. Das derartig gewonnene aufgerasterte Bildmotiv kann dann zur Herstellung von Druckplatten 25 und zum Druck von Aufzeichnungsträgern 26 verwendet werden.

Vorteilhaft bei diesem Herstellungsverfahren ist, dass sich jede beliebig komplizierte Struktur mit einfachen, fototechnischen Methoden in ein Kontaktraster umsetzen lässt. Die Halbtonwiedergabe eines mit einem solchen Kontaktraster aufgerasterten Bildmotivs durch die den jeweiligen Halbton wiedergebenden, sich verdickenden oder verjüngenden Strukturelemente der Rastergrundstruktur lässt sich genau einstellen, d.h. die Anzahl der Stufen lässt sich beliebig – im Rahmen der technischen Möglichkeiten – erhöhen, so dass man, falls erwünscht, einen quasikontinuierlichen bis kontinuierlichen Grauwert bzw. Schwärzungsverlauf erhalten kann. Ausserdem lässt sich die Halbtonwiedergabe durch die genaue Einstellung der Stufenhöhen beliebig verschieben, so dass sich bestimmte Graustufen der Vorlage bei der Aufrasterung in das gewünschte Verhältnis bringen lassen.

Ein technisches Hilfsmittel sowohl für die Einzelstufen-Verfahren sowie für das Kontaktrasterverfahren bietet beim Arbeiten mit sehr fein strukturierten Bildmotiven und Rastern die Vergrösserungstechnik. Bei der Aufrasterung eines Bildmotivs tritt die Bildinformation umso deutlicher und genauer hervor, je enger und feiner die Struktur des Rasters ist. Je mehr Stufen man verwendet, desto besser und genauer werden die Halbtöne des Bildmotivs wiedergegeben.

Zu diesem Zweck ist es vorteilhaft, bei feinstrukturierten Rastern und beim Arbeiten mit einer grossen Stufenzahl, d.h. mehreren aufgeweiteten Rasterstrukturen, vergrösserte Rasterpositive bzw. Negative zu verwenden, da sich von einem Raster wie in Fig. 17 ohne grössere Probleme z.B. 50 Rasternegative bzw. -positive wachsender Strukturstärke herstellen lassen, wenn man mit zehn-, fünfzehnfacher oder noch stärkerer Vergrösserung arbeitet. Vergrössert man das aufzurasternde Halbtonbildmotiv, z.B. die Muschel auf Fig. 12 ebenfalls entsprechend und stellt davon 50 Tonwertauszüge wachsender Strukturstärke her (d.h. Tonwertauszüge, die 50 unterschiedliche Grauwertbereiche der Halbtonvorlage wiedergeben), so erhält man mit denselben Verfahrensschritten wie in den obigen Verfahren geschildert eine vergrösserte gerasterte Druckvorlage, die anschliessend wieder auf das gewünschte Mass verkleinert wird.

Benutzt man anderseits sehr wenig Stufen und sollen die Übergänge in den Rasterstrukturen zwischen zwei Stufen abgeschwächt bzw. etwas weicher gestaltet werden, arbeitet man vorzugsweise mit stark verkleinerten Bildmotiven und Rasterstrukturen. Die so entstehende Druckvorlage wird am Ende des Verfahrens wieder auf das gewünschte Mass vergrössert und zeigt dann in den Übergangsbereichen zwischen den verschiedenen Strukturstärken des Rasters bzw. Rasterbreiten einen kontinuierlichen Verlauf. Dieser Effekt lässt sich, wie schon oben erwähnt, durch den Gradationsverlauf des verwendeten Strichmaterials erklären.

Ein anderes Verfahren zur Erzielung einer besseren optischen Aufbereitung der gerasterten Druckvorlage für den Druck besteht darin, das schon aufgerasterte Bildmotiv vor dem Einkopieren der Rastergrundstruktur bzw. Originalrasterstruktur in einer Reprokamera etwas unscharf auf Strichmaterial zu reproduzieren und erst im Anschluss daran die Grundrasterstruktur einzukopieren. Die etwas unscharfe Reproduktion hat ebenfalls den Effekt, die Rasterstufungen im aufgerasterten Bildmotiv weicher zu zeichnen. Dieses Verfahren ist auch anwendbar bei Verwendung eines Kontaktrasters, wenn die schmalste Stufe im Kontaktraster ausgelassen ist.

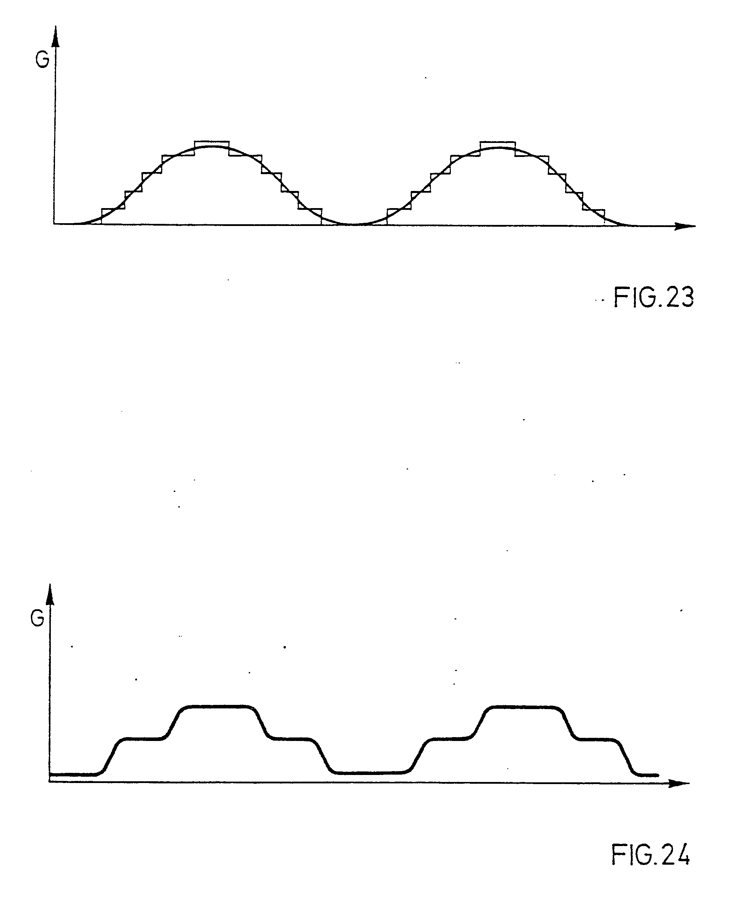

Abschliessend zum fototechnischen «Kontaktraster-Halbton-Verfahren» sei noch erwähnt, dass sich mit diesem Verfahren neue Wege für die Herstellung klassischer Kontaktraster wie Punkt-, Linien- oder Kreuzraster eröffnen ohne auf die Glasgravurrasterherstellung angewiesen zu sein. So lassen sich etwa gebräuchliche Linienraster oder andere Rasterstrukturen in grosser Zahl und hoher Qualität herstellen, wenn man ein Mehrstufenkontaktraster, d.h. ein mit mehreren aufgeweiteten Rasterstrukturen herstelltes Kontaktraster, in vergrössertem Massstab mit einer sehr grossen Stufenzahl herstellt, dieses Kontaktraster etwas unscharf reproduziert, anschliessend auf das geforderte Ausmass verkleinert und von diesem Original die gewünschte Anzahl Duplikate herstellt. Damit hat man also die Möglichkeit, über das Kontaktrasterverfahren eine beliebig hohe Stückzahl von identischen Rastern, welche einen quasikontinuierlichen bis kontinuierlichen Grauwert- bzw. Schwärzungsverlauf aufweisen und in diesem genau einstellbar sind, auf wirtschaftliche Art ohne Umweg über die Herstellung von Glasgravurraster anzufertigen. Mit diesem Verfahren kann man nicht nur den Gradationsverlauf eines klassischen Kontaktrasters (siehe Fig. 23) stufenförmig beliebig genau approximieren und mit den oben erwähnten technischen Hilfsmitteln fast kontinuierlich gestalten, es lässt sich sogar jeder beliebige Grauwert bzw. Schwärzungsverlauf im Kontaktraster erzielen, so z. B. der in Fig. 24 dargestellte, mit dem sich ein Halbtonbildmotiv in ein Rasterbild mit stark betonten Hell-Dunkel-Kontrast umsetzen lässt.

Im folgenden werden noch kurz zwei «technisierte» Varianten des Kontaktrasterverfahrens skizziert.

Nachdem man wie bei den oben dargestellten «technisierten» Einzelstufenverfahren eine Grundrasterstruktur und aufgeweitete Rasterstrukturen mittels Computergrafik oder mit Hilfe der Scanningeinrichtung erstellt hat – wobei die Informationen über Lage und Form der Rasterelemente für jede aufgeweitete Rasterstruktur separat gespeichert sind – wird jeder aufgeweiteten Rasterstruktur ein Grauwert zugeordnet, der der gespeicherten Lage- und Forminformation der entsprechenden, aufgeweiteten Rasterstruktur zugefügt wird.

Überlagert man diese Informationen, d.h. addiert die zugeordneten Grauwerte punktweise für jede aufgeweitete Rasterstruktur und speichert diese resultierende Information ab, so erhält man damit ein «elektronisches Kontaktraster», d.h. eine Rasterstruktur, deren Form punktweise gespeichert ist, wobei jedem Punkt ein Grau- bzw. Schwärzungswert zugeordnet ist. Mit dieser Information kann z.B. der Laserstrahlschreiber gesteuert werden, der dieses «elektronische Kontaktraster» auf ein unbelichtetes Halbtonmaterial belichtet bzw. überträgt, so dass man ein klassisches fotografisches Kontaktraster erhält.

Es ist aber auch eine direkte «elektronische» Aufrasterung möglich, indem die Halbtonvorlage gescannt, deren Grauwerte punktweise gespeichert und mit dem gespeicherten «elektronischen» Kontaktraster derart überlagert werden, dass die Grauwerte des elektronischen Kontaktrasters und der Halbtonvorlage addiert werden und bei Überschreiten einer definierten, empirisch zu ermittelnden Schwelle für jeden Punkt eine resultierende Information abgespeichert wird. Diese resultierenden Information (sie sind die «Forminformation» des aufgerasterten Bildmotivs) geben dann das aufgerasterte Bildmotiv durch unterschiedliche Strukturstärken der Rastergrundstruktur wieder, welches auf dem Bildschirm angezeigt und/oder mittels des Laserstrahlschreibers direkt auf Druckplatten oder erst auf ein unbelichtetes Strichmaterial übertragen werden kann.

Eine etwas abgewandelte Variante zur Erzeugung eines «elektronischen Kontaktrasters» besteht darin, wie oben eine Rastergrundstruktur zu erzeugen, deren Form gespeichert wird. Aus dieser Rastergrundstruktur greift man ein charakteristisches Rasterelement heraus und definiert für dieses Rasterelement einen Grauwert bzw. Schwärzungsverlauf (z. B. per Computergrafik, indem für verschiedene Querschnitte des charakteristischen Rasterelements ein Schwärzungs- bzw. Grauwertverlauf definiert wird, den man auch perspektivisch auf dem Bildschirm darstellen kann, so dass sich ein räumliches Bild des Schwärzungs- bzw. Grauwertverlaufs in einem Rasterelement ergibt). Diese für ein Rasterelement erzeugte Information wird auf die gesamte Rastergrundstruktur übertragen, so dass man ebenfalls ein «elektronisches Kontaktraster» erhält, mit dem man wie schon oben dargestellt weiterarbeitet, indem entweder elektronisch aufgerastert oder ein fotografisches Kontaktraster erstellt wird.

Abschliessend seien noch einmal die wesentlichen Vorteile des erfinderischen Verfahrens aufgeführt. Allen Varianten gemeinsam ist, dass sich beliebige Strukturen als Raster verwenden lassen und dass die Umsetzung von Grauwert der Vorlage in eine bestimmte Strukturstärke einer Rastergrundstruktur in allen Einzelheiten gezielt steuerbar ist. Ein Vorteil der Einzelstufenverfahren ist, falls erwünscht, eine gewisse «Exklusivität» und Einmaligkeit der Rasterstrukturen und der Aufrasterung, da sich ein derartig aufgerastertes Bildmotiv ohne genaue Kenntnis des Herstellungsrezepts (d.h. Aufweitungsgrad der Rastergrundstruktur, genauer Verlauf der Rastergrundstruktur, Zuordnung von aufgeweiteter Rasterstruktur zu Grauwertbereich der aufzurasternden Halbtonvorlage usw.) nicht reproduzieren lässt. Neue Möglichkeiten ergeben sich auch für den Banknoten- und Wertpapierdruck, da sich hier erstmals ein Bildmotiv durch ein beliebig kompliziertes Sicherheitslinienmuster wiedergeben lässt. So ist es beispielsweise bei Verwendung zentrischer Guillochen möglich, die Bildinformation auch mehrfarbig durch den zentralen Bereich des Sicherheitslinienmusters wiederzugeben und in einfache Guillochenlinien ohne Bildinformation auslaufen zu lassen. Der Linienverlauf der Guillochen wäre dabei ununterbrochen auch durch das Bildmotiv zu verfolgen. Durch diese Integration einer Bildinformation in das Sicherheitslinienmuster werden Fälschungs- und Nachahmungsversuche erheblich erschwert.

Eine spezielle drucktechnische und sicherheitstechnisch hochinteressante Möglichkeit, die sich aus den obigen Verfahren für den Druck von Aufzeichnungsträgern, insbesondere Wertpapieren ergibt, besteht darin, die unterschiedlichen, aufgerasterten Grauwertbereiche des Halbtonbildmotivs auf zwei verschiedene Druckplatten zu übertragen (z. B. auch durch direktes Gravieren der Druckplatten mittels des EDV-gesteuerten Laserstrahlschreibers oder durch die oben geschilderten Techniken), wobei eine Druckplatte für den Druck der Vorderseite und die andere Druckplatte für den Druck der Rückseite des Aufzeichnungsträgers verwendet wird. Ein Teil der Bildinformation (eine Überlagerung von ausgewählten aufgerasterten Grauwertbereichen) befindet sich dann auf der Vorderseite, der andere Teil der Bildinformation (die restlichen überlagerten und aufgerasterten Grauwertbereiche) auf der Rückseite des Aufzeichnungsträgers, so dass im Durchlicht die volle aufgerasterte Bildinformation sichtbar wird. Dazu muss natürlich der für die Rückseite bestimmte aufgerasterte Bildanteil in seitenverkehrter Form auf die Druckplatte übertragen und beim Druck des Aufzeichnungsträgers auf passergenauen Druck geachtet werden.

Ein besonderer Vorteil der fototechnischen Verfahren ist es, dass sie sich mit relativ einfachen technischen Möglichkeiten realisieren lassen und trotzdem Ergebnisse liefern, die mit der klassischen Rastertechnik undenkbar sind.

Abgesehen von dem grossen apparativen Aufwand bei dem «technisierten» Verfahren sind diese besonders dazu geeignet, neuartige Rasterformen mit beliebigem Grauwert- bzw. Schwärzungsverlauf zu erproben, wobei sämtliche Parameter sofort änderbar und die Auswirkungen dieser Veränderung praktisch gleichzeitig optisch darstellbar sind, so dass sich damit auch exklusive «Rasterwünsche» erfüllen lassen, sowohl was die Herstellung von Kontaktrastern wie auch was die direkte elektronische Aufrasterung, das Herstellen von Druckplatten oder Druckvorlagen betrifft.

**Patentansprüche**

1. Verfahren zur Aufrasterung von Halbtonbildmotiven, wobei die verschiedenen Halbtöne bzw. Grauwerte des Bildmotivs durch eine symmetrische Aufweitung der Strukturelemente einer Rastergrundstruktur wiedergegeben werden, dadurch gekennzeichnet, dass

a) von der Rastergrundstruktur ein der Anzahl der umzusetzenden Grauwertbereiche des Bildmotivs entsprechender Satz von symmetrisch aufgeweiteten Rasterstrukturen erzeugt wird, wobei der Aufweitungsgrad stufenweise zunimmt,

b) der gesamte Grauwertverlauf des Halbtonbildmotivs in einzelne Grauwertbereiche aufgeteilt wird,

c) jedem der unter b) definierten Grauwertbereiche eine bestimmte der unter a) erzeugten symmetrisch aufgeweiteten Rasterstrukturen zugeordnet wird,

d) die aufgeweiteten Rasterstrukturen einzeln oder in zusammengefasster Form den ihnen unter c) zugeordneten Grauwertbereichen des Halbtonbildmotivs, die ebenfalls einzeln oder in zusammengefasster Form vorliegen können, überlagert werden,

d) die aus dieser Überlagerung resultierende Information gespeichert oder aufgezeichnet wird, so dass die Anteile des Halbtonbildmotivs, die einen Grauwert aus einem der unter c) ausgewählten Grauwertbereiche aufweisen, lokal durch die diesem Grauwertbereich zugeordnete, aufgeweitete Rasterstruktur wiedergegeben werden.

2. Verfahren nach Anspruch 1, dadurch gekennzeichnet, dass

a) von der Rastergrundstruktur (1) ein der Anzahl der umzusetzenden Grauwertbereiche des Bildmotivs entsprechender Satz von stufenweise symmetrisch aufgeweiteten Rasterstrukturen in Form von als Negativ- (9, 11) bzw. Positivfilm vorliegenden Strichrepros wachsender Strukturstärke hergestellt werden,

b) vom aufzurasternden Bildmotiv (13) dieselbe Anzahl Tonwertauszüge als Negativ- (20, 22) bzw. Positivstrichfilm hergestellt werden, von denen jeder einen bestimmten Grauwertbereich des Halbtonbildmotivs wiedergibt,

c) das als Negativ- (9) bzw. Positivfilm vorliegende Strichrepro mit der am stärksten aufgeweiteten Rasterstruktur aus a) zusammen mit dem als Negativ (22) bzw. Positivfilm vorliegenden Tonwertauszug aus b), welcher die Anteile des Halbtonbildmotivs mit den dunkelsten Grauwerten wiedergibt, in Kontaktanordnung auf ein unbelichtetes Strichmaterial (24) gelegt wird,

d) diese Anordnung solange belichtet wird, bis in den Bereichen des Strichmaterials, wo die Anordnung vollkommen lichtdurchlässig ist, eine vollständige Schwärzung erfolgt ist, so dass der durch den Tonwertauszug bestimmte dunkelste Grauwertbereich des Halbtonbildmotivs durch die Rasterstruktur mit der stärksten Aufweitung wiedergegeben wird,

e) mit den Strichrepros jeweils abnehmender Aufweitung aus a) und den Tonwertauszügen aus b), welche jeweils einen helleren Grauwertbereich des Halbtonbildmotivs wiedergeben und jeweils einem neuen unbelichtetem Strichmaterial analog verfahren wird,

f) die als Positiv- bzw. Negativfilm vorliegenden Strichmaterialien (25), von denen jedes einen anderen Grauwertbereich des Halbtonbildmotivs durch eine diesem entsprechende Aufweitung der Rastergrundstruktur wiedergibt, zur Herstellung eines aufgerasterten Gesamtbildmotivs (26) verwendet werden. (Fig. 1).

3. Verfahren nach Anspruch 2, dadurch gekennzeichnet, dass bei jedem Belichtungsvorgang der Anordnung Tonwertauszug/Rasterstruktur/Strichmaterial bei Verfahrensschritt e) immer auf ein und dasselbe Strichmaterial belichtet wird.

4. Verfahren nach Anspruch 1, dadurch gekennzeichnet, dass

a) von der Rastergrundstruktur ein der Anzahl der umzusetzenden Grauwertbereiche des Bildmotivs entsprechender Satz von stufenweise symmetrisch aufgeweiteten Rasterstrukturen in Form von als Negativ- oder Positivfilm vorliegenden Strichrepros wachsender Strukturstärke hergestellt werden,

b) das als Negativ- bzw. Positivfilm vorliegende Strichrepro mit der am geringsten aufgeweiteten Rasterstruktur zusammen mit einem Halbtonnegativ- bzw. Halbtonpositivfilm des aufzurasternden Bildmotivs in Kontaktanordnung auf ein unbelichtetes Strichmaterial gelegt wird,

c) diese Anordnung solange belichtet wird, bis die hellsten Grauwertbereiche des Halbtonbildmotivs durch die Rasterstruktur mit der geringsten Aufweitung wiedergegeben werden,

d) mit den Strichrepros jeweils zunehmender Aufweitung und jeweils einem neuen unbelichteten Strichmaterial eben so verfahren wird, wobei die Belichtungsdauer derart verkürzt wird, dass entsprechend dunklere Grauwerte des Halbtonbildmotivs in diese stärker aufgeweitete Rasterstruktur umgesetzt werden,

e) die als Positiv- bzw. Negativfilm vorliegenden Strichmaterialien, von denen jedes einen anderen Grauwertbereich des Halbtonbildmotivs durch eine diesem entsprechende Aufweitung der Rastergrundstruktur wiedergibt, zur Herstellung eines aufgerasterten Gesamtbildmotivs verwendet werden.

5. Verfahren nach Anspruch 4, dadurch gekennzeichnet, dass bei jedem Belichtungsvorgang der Anordnung Halbtonnegativ/Rasterstruktur/Strichmaterial bei Verfahrensschritt e) immer auf ein und dasselbe Strichmaterial belichtet wird.

6. Verfahren nach Anspruch 1, dadurch gekennzeichnet, dass

a) von der Rastergrundstruktur stufenweise symmetrisch aufgeweitete Rasterstrukturen in Form von als Negativ- (5, 7) bzw. Positivfilm vorliegenden Strichrepros zunehmender Strukturstärke hergestellt werden,

b) jedes dieser Strichrepros einzeln in Kontaktanordnung nacheinander auf ein geeignetes Halbtonmaterial (73) gelegt und jeweils eine bestimmte Zeitspanne belichtet wird, so dass man als Endergebnis ein Positiv- (73) bzw. Negativkontaktraster erhält, welches einen durch den unterschiedlichen Aufweitungsgrad der einzelnen Rasterstrukturen und die Belichtungszeiten bestimmten Schwärzungsverlauf des Rasterprofils aufweist,

c) das Halbtonbildmotiv mit diesem Kontaktraster in bekannter Weise aufgerastert wird. (Fig. 20)

7. Verfahren nach einem der Ansprüche 1–6, dadurch gekennzeichnet, dass die Rasterstrukturen zunehmender Aufweitung auf fotografischem Wege durch gezieltes Überstrahlen eines jeweils neuen Strichmaterials hergestellt werden.

8. Verfahren nach einem der Ansprüche 1–5, dadurch gekennzeichnet, dass die Tonwertauszüge in bekannter Weise auf fotografischem Wege hergestellt werden.

9. Verfahren nach einem der Ansprüche 1–6, dadurch gekennzeichnet, dass die Rastergrundstruktur und die aufgeweiteten Rasterstrukturen mittels computergrafischer Techniken erzeugt und mittels eines gesteuerten Laserstrahlschreibers auf jeweils ein neues Strichmaterial übertragen werden.

10. Verfahren nach einem der Ansprüche 1–5, dadurch gekennzeichnet, dass die Tonwertauszüge über eine Scanningeinrichtung gewonnen werden.

11. Verfahren nach einem der Ansprüche 1–7, dadurch gekennzeichnet, dass nach Aufrasterung des Halbtonbildmotivs die Rastergrundstruktur passergenau in das aufgerasterte Bildmotiv einkopiert wird.

12. Verfahren nach Anspruch 1, dadurch gekennzeichnet, dass

a) die Rastergrundstruktur und die aufgeweiteten Rasterstrukturen mittels computergrafischer Techniken oder durch Scanning von fotografischen oder grafischen Vorlagen erzeugt werden,

b) die Lage und Form der Rasterelemente für die Rastergrundstruktur und die aufgeweiteten Rasterstrukturen separat gespeichert werden,

c) der Grauwertumfang des Halbtonbildmotivs in Grauwertbereiche eingeteilt und das Halbtonbildmotiv derart gescant wird, dass die Anteile des Halbtonbildmotivs, welche einen Grauwert aus einem dieser Bereiche aufweisen, für jeden Grauwertbereich separat gespeichert werden,

d) die Grauwertbereiche jeweils einer aufgeweiteten Rasterstruktur zugeordnet werden,

e) für jeden Grauwertbereich separat die Informationen von aufgeweiteter Rasterstruktur und zugeordnetem Grauwertanteil des Halbtonbildmotivs punktweise derart überlagert werden, dass eine resultierende Information gebildet und gespeichert wird, die Auskunft darüber gibt, ob an diesem Punkt Rasterstruktur und Bildanteil vorliegt, so dass jeder Grauwertanteil des Bildmotivs durch die zugeordnete Rasterstruktur wiedergegeben wird,

f) diese Informationen über die einzelnen aufgerasterten Grauwertanteile des Halbtonbildmotivs zur Herstellung eines aufgerasterten Bildmotivs verwendet werden.

13. Verfahren nach Anspruch 12, dadurch gekennzeichnet, dass mit den Informationen über die aufgerasterten Grauwertanteile des Halbtonbildmotivs separat für jeden Grauwertbereich ein Laserstrahlschreiber gesteuert wird, der die aufgerasterten Grauwertanteile auf jeweils separate Filmschichten belichtet oder direkt auf Druckplatten überträgt.

14. Verfahren nach Anspruch 12, dadurch gekennzeichnet, dass die verschiedenen aufgerasterten Grauwertanteile erst überlagert und dann auf eine Filmschicht oder eine Druckplatte übertragen werden.

15. Verfahren nach Anspruch 1, dadurch gekennzeichnet, dass

a) die Rastergrundstruktur und die aufgeweiteten Rasterstrukturen mittels computergrafischer Techniken oder durch Scanning von fotografischen oder grafischen Vorlagen erzeugt werden,

b) die Lage und Form der Rasterelemente für die Rastergrundstruktur und die aufgeweiteten Rasterstrukturen separat gespeichert werden,

c) jeder aufgeweiteten Rasterstruktur ein Grauwert zugeordnet und der Information über Lage und Form der aufgeweiteten Rasterstruktur zugefügt wird,

d) diese Informationen über die aufgeweiteten Rasterstrukturen derart überlagert werden, dass die Grauwerte punktweise addiert werden, so dass jedem Punkt der resultierenden Rasterstruktur ein Grauwert zugeordnet ist und diese Information gespeichert wird, so dass sich ein «elektronisches Kontaktraster» ergibt,

e) eine Halbtonvorlage derart gescant wird,

dass für jeden Punkt der Grauwert gespeichert wird,

f) die Informationen über die Grauwerte des Halbtonbildmotivs mit den Informationen des «elektronischen Kontaktrasters» derart überlagert werden, dass für jeden Punkt dieser überlagerten Anordnung die Grauwerte addiert werden und bei Überschreiten eines Schwellwertes für diesen Punkt eine positive Information abgespeichert wird, so dass diese resultierenden Informationen das aufgerasterte Bildmotiv wiedergeben.

16. Verfahren zur Aufrasterung von Halbtonbildmotiven, wobei die verschiedenen Halbtöne bzw. Grauwerte des Bildmotivs durch eine Aufweitung der Strukturelemente einer der Form nach beliebigen Rastergrundstruktur wiedergegeben werden, dadurch gekennzeichnet, dass

a) die Rastergrundstruktur mittels computergrafischer Techniken oder durch Scanning von fotografischen oder grafischen Vorlagen erzeugt wird,

b) die Lage und Form der Rasterelemente für die Rastergrundstruktur gespeichert wird,

c) mittels computergrafischer Techniken für einen oder mehrere Querschnitte eines charakteristischen Rasterelements ein Grauwert- bzw. Schwärzungsverlauf definiert und gespeichert wird,

d) dieser Grauwertverlauf auf die gesamte Rasterstruktur übertragen und gespeichert wird, so dass man ein «elektronisches Kontaktraster» erhält,

e) dann eine Halbtonvorlage derart gescannt wird, dass für jeden Punkt der Grauwert gespeichert wird,

f) die Informationen über die Grauwerte des Halbtonbildmotivs mit den Informationen des «elektronischen Kontaktrasters» derart überlagert werden, dass für jeden Punkt dieser überlagerten Anordnung die Grauwerte addiert werden und bei Überschreiten eines Schwellwertes für diesen Punkt eine positive Information abgespeichert wird, so dass diese resultierenden Informationen das aufgerasterte Bildmotiv wiedergeben.

17. Verfahren nach einem der Ansprüche 15 oder 16, dadurch gekennzeichnet, dass mit den gespeicherten Informationen über das aufgerasterte Halbtonbildmotiv ein Laserstrahlschreiber gesteuert wird, der dieses auf eine Filmschicht, ein Fotopapier, eine Druckplatte oder ein Trägermaterial überträgt.

18. Verfahren zur Herstellung eines Filmkontaktrasters, dadurch gekennzeichnet, dass

a) von einer Rastergrundstruktur symmetrisch aufgeweitete Rasterstrukturen in Form von als Negativ- oder Positivfilm vorliegenden Strichrepros wachsender Strukturstärke hergestellt werden,

b) jedes dieser Strichrepros einzeln in Kontaktanordnung nacheinander auf ein geeignetes Halbtonmaterial gelegt und jeweils eine bestimmte Zeitspanne belichtet wird, so dass man als Endergebnis ein Positiv- bzw. Negativkontaktraster erhält, welches einen durch den unterschiedlichen Aufweitungsgrad der einzelnen Rasterstrukturen und die Belichtungszeiten bestimmten und genau einstellbaren Schwärzungsverlauf des Rasterprofils aufweist.

19. Verfahren zur Herstellung eines Filmkontaktrasters, dadurch gekennzeichnet, dass

a) eine Rastergrundstruktur und symmetrisch aufgeweitete Rasterstrukturen mittels computergrafischer Techniken oder durch Scanning von fotografischen oder grafischen Vorlagen erzeugt werden,

b) die Lage und Form der Rasterelemente für die Rastergrundstruktur und die aufgeweiteten Rasterstrukturen separat gespeichert werden,

c) jeder aufgeweiteten Rasterstruktur ein Grauwert zugeordnet und der Information über Lage und Form der aufgeweiteten Rasterstruktur zugeführt wird,

d) diese Informationen über die aufgeweiteten Rasterstrukturen derart überlagert werden, dass die Grauwerte punktweise addiert werden, so dass jedem Punkt der resultierenden Rasterstruktur ein Grauwert zugeordnet ist und diese Information gespeichert wird, so dass sich ein «elektronisches Kontaktraster» ergibt,

e) mit diesen Informationen ein Laserstrahlschreiber gesteuert wird, der das «elektronische Kontaktraster» auf ein Halbtonmaterial überträgt.

20. Verfahren zur Herstellung eines Filmkontaktrasters, dadurch gekennzeichnet, dass

a) die Rastergrundstruktur mittels computergrafischer Techniken oder durch Scanning von fotografischen oder grafischen Vorlagen erzeugt wird,

b) die Lage und Form der Rasterelemente für die Rastergrundstruktur gespeichert wird,

c) mittels computergrafischer Techniken für einen oder mehrere Querschnitte eines charakteristischen Rasterelements ein Grauwert- bzw. Schwärzungsverlauf definiert und gespeichert wird,

d) dieser Grauwertverlauf auf die gesamte Rasterstruktur übertragen und gespeichert wird, so dass man ein «elektronisches Kontaktraster» erhält,

e) mit diesen Informationen ein Laserstrahlschreiber gesteuert wird, der das «elektronische Kontaktraster» auf ein Halbtonmaterial überträgt.

21. Aufgerastertes Bildmotiv, hergestellt nach einem der vorhergehenden Ansprüche, dadurch gekennzeichnet, dass die Rastergrundstruktur ein Guillochenmuster ist, welches Verschlingungen, T-Kreuzungen und Mehrfachkreuzungen aufweist, wobei die Maschenweite a der bei Linienkreuzungen entstehenden Maschen und die Linienstärke b so aufeinander abgestimmt sind, dass die Linienstärke b immer kleiner als die Hälfte der Maschenweite a ist.

22. Aufgerastertes Bildmotiv nach Anspruch 21, dadurch gekennzeichnet, dass die als Druckfarbe auf einem Trägermaterial vorliegenden Linien des Guillochenmusters aus verschiedenen Farbschichten bestehen, so dass sich ein stufenpyramidenartiger Querschnitt ergibt.

23. Aufgerastertes Bildmotiv nach Anspruch 22, dadurch gekennzeichnet, dass eine oder mehrere Farbschichten aus metallischen, metameren, thermochromen oder fotochromen Farben bestehen.

24. Aufgerastertes Bildmotiv nach Anspruch 22, dadurch gekennzeichnet, dass ein Teil der durch die aufgeweiteten Rasterstrukturen wiedergegebenen Grauwertbereiche des Halbtonbildmotivs auf der Vorderseite eines durchscheinenden Trägermaterials angeordnet ist, der andere Teil auf der Rückseite, so dass das vollständige aufgerasterte Bildmotiv nur im Durchlicht erscheint.

**Claims**

1. A method for screening half-tone picture themes, the various half-tones or grey tones of the picture theme being reproduced by a symmetrical broadening of the structural elements of a basic screen structure, characterized in that

a) a set of symmetrically broadened screen structures corresponding to the number of grey tone areas of the picture theme to be converted is produced from the basic screen structure, the degree of broadening increasing in steps,

b) the entire grey tone pattern of the half-tone picture theme is divided into individual grey tone areas,

c) each of the grey tone areas defined in b) has assigned thereto a specific one of the symmetrically broadened screen structures produced in a),

d) the broadened screen structures are superimposed singly or in a combined form on the grey tone areas of the half-tone picture theme assigned thereto in c), which may likewise be present singly or in a combined form,

d) the information resulting from this superimposition is stored or recorded so that the portions of the half-tone picture theme having a grey tone from one of the grey tone areas selected in c) are reproduced locally by the broadened screen structure assigned to this grey tone area.

2. The method according to claim 1, characterized in that

a) a set of screen structures symmetrically broadened in steps corresponding to the number of the grey tone areas of the picture theme to be converted is produced from the basic screen structure (1) in the form of line copies of increasing structural width existing as negative (9, 11) or positive film,

b) the same number of tone separations is produced from the picture theme (13) to be screened as negative (20, 22) or positive line film, each of which reproduces a specific grey tone area of the half-tone picture theme,

c) the line copy existing as a negative (9) or positive film with the most broadened screen structure of a) together with the tone separation existing as a negative (22) or positive film of b) which reproduces the portions of the half-tone picture theme with the darkest grey tones are placed in contact arrangement on an unexposed line material (24),

d) this arrangement is exposed until complete blackening takes place in the areas of the line material where the arrangement is completely permeable to light, so that the darkest grey tone area of the half-tone picture theme determined by the tone separation is reproduced by the screen structure with the greatest broadening,

e) one proceeds analogously with the line copies of decreasing broadening in each case of a) and the tone separations of b) each reproducing a lighter grey tone area of the half-tone picture theme and with a new unexposed line material in each case,

f) the line materials (25) existing as positive or negative film each of which reproduces a different grey tone area of the half-tone picture theme by a broadening of the basic screen structure corresponding thereto, are used to produce a screened overall picture theme (26) (Fig. 1).

3. The method according to claim 2, characterized in that in each exposure process of the arrangement tone separation/screen structure/line material in procedural step e) one and the same line material is always exposed onto.

4. The method according to claim 1, characterized in that

a) a set of screen structures symmetrically broadened in steps corresponding to the number of grey tone areas of the picture theme to be converted is produced from the basic screen structure in the form of line copies of increasing structural width existing as negative or positive film,

b) the line copy existing as negative or positive film with the least broadened screen structure together with a half-tone negative or half-tone positive film of the picture theme to be screened is placed in contact arrangement on an unexposed line material,

c) this arrangement is exposed until the lightest grey tone areas of the half-tone picture theme are reproduced by the screen structure with the least broadening,

d) one proceeds the same way with the line copies of increasing broadening in each case and with a new unexposed line material in each case, the exposure time being shortened in such a way that correspondingly darker grey tones of the half-tone picture theme are converted into this more broadened screen structure,

e) the line materials existing as positive or negative film each of which reproduces a different grey tone area of the half-tone picture theme by a broadening of the basic screen structure corresponding thereto, are used to produce a screened overall picture theme.

5. The method according to claim 4, characterized in that in each exposure process of the arrangement half-tone negative/screen structure/line material in procedural step e) one and the same line material is always exposed onto.

6. The method according to claim 1, characterized in that

a) screen structures symmetrically broadened in steps are produced from the basic screen structure in the form of line copies of increasing structural width existing as negative (5, 7) or positive film,

b) each of these line copies is placed singly in contact arrangement successively on an appropriate half-tone material (73) and exposed for a certain time period in each case so that the final result obtained is a positive (73) or negative contact screen having a blackening pattern of the screen profile determined by the different degree of broadening of the individual screen structures and the exposure times,

c) the half-tone picture theme is screened with this contact screen in the known manner (Fig. 20).

7. The method according to any of claims 1 to 6, characterized in that the screen structures of increasing broadening are produced photographically by selectively irradiating a new line material in each case.

8. The method according to any of claims 1 to 5, characterized in that the tone separations are produced photographically in the know manner.

9. The method according to any of claims 1 to 6, characterized in that the basic screen structure and the broadened screen structures are produced by means of computer graphic techniques and transferred by means of a controlled laser beam recorder onto a new line material in each case.

10. The method according to any of claims 1 to 5, characterized in that the tone separations are obtained via a scanning means.

11. The method according to any of claims 1 to 7, characterized in that after the half-tone picture theme is screened the basic screen structure is copied into the screened picture theme so as to fit precisely.

12. The method according to claim 1, characterized in that

a) the basic screen structure and the broadened screen structures are produced by means of computer graphic techniques or by scanning from photographic or graphic originals,

b) the position and shape of the screen elements are stored separately for the basic screen structure and the broadened screen structures,

c) the grey tone extent of the half-tone picture theme is divided into grey tone areas and the half-tone picture theme scanned in such a way that the portions of the half-tone picture theme having a grey tone from one of these areas are stored separately for each grey tone area,

d) the grey tone areas are each assigned to a broadened screen structure,

e) the information of broadened screen structure and assigned grey tone portion of the half-tone picture theme is superimposed separately point by point for each grey tone area in such a way as to form and store resulting information saying whether a screen structure and a picture portion are present at this point so that each grey tone portion of the picture theme is reproduced by the assigned screen structure,

f) this information on the individual screened grey tone portions of the half-tone picture theme is used to produce a screened picture theme.

13. The method according to claim 12, characterized in that the information on the screened grey tone portions of the half-tone picture theme is used for each grey tone area separately to control a laser beam recorder which exposes each screened grey tone portion onto a separate film layer or transfers them directly onto printing plates.

14. The method according to claim 12, characterized in that the different screened grey tone portions are first superimposed and then transferred onto a film layer or a printing plate.

15. The method according to claim 1, characterized in that

a) the basic screen structure and the broadened screen structures are produced by means of computer graphic techniques or by scanning photographic or graphic originals,

b) the position and shape of the screen elements are stored separately for the basic screen structure and the broadened screen structures,

c) each broadened screen structure has a grey tone assigned thereto which is added to the information about the position and shape of the broadened screen structure,

d) this information about the broadened screen structures is superimposed in such a way that the grey tones are added point by point so that a grey tone is assigned to each point of the resulting screen structure and this information is stored so as to yield and «electronic contact screen»,

e) a half-tone original is scanned in such a way that the grey tone is stored for each point,

f) the information about the grey tones of the half-tone picture theme is superimposed with the information of the «electronic contact screen» in such a way that the grey tones are added for each point of this superimposed arrangement and when a threshold is exceeded a positive piece of information is stored for this point so that this resulting information reproduces the screened picture theme.

16. A method for screening half-tone picture themes wherein the various half-tones or grey tones of the picture theme are reproduced by a broadening of the structural elements of a basic screen structure having any shape whatsoever, characterized in that

a) the basic screen structure is produced by means of computer graphic techniques or by scanning photographic or graphic originals,

b) the position and shape of the screen elements for the basic screen structure is stored,

c) a grey tone or blackening pattern is defined and stored by means of computer graphic techniques for one or more cross-sections of a characteristic screen element, ·

d) this grey tone pattern is transferred to the overall screen structure and stored so as to obtain an «electronic contact screen»,

e) a half-tone original is then scanned in such a way as to store the grey tone for each point,

f) the information about the grey tones of the half-tone picture theme is superimposed with the information of the «electronic contact screen» in such a way that the grey tones are added for each point of this superimposed arrangement and if a

threshold is exceeded a positive piece of information is stored for this point so that this resulting information reproduces the screened picture theme.

17. The method according to either of claims 15 or 16, characterized in that the stored information about the screened half-tone picture theme is used to control a laser beam recorder which transfers it onto a film layer, photographic paper, a printing plate or a carrier material.

18. A method for producing a film contact screen, characterized in that

a) symmetrically broadened screen structures are produced from a basic screen structure in the form of line copies of increasing structural width existing as negative or positive film,

b) each of these line copies is successively placed singly in contact arrangement on an appropriate half-tone material and exposed for a certain time period in each case so that the final result obtained is a positive or negative contact screen having a blackening pattern of the screen profile which is precisely adjustable and determined by the different degree of broadening of the individual screen structures and the exposure times.

19. A method for producing a film contact screen, characterized in that

a) a basic screen structure and symmetrically broadened screen structures are produced by means of computer graphic techniques or by scanning photographic or graphic originals,

b) the position and shape of the screen elements are stored separately for the basic screen structure and the broadened screen structures,

c) each broadened screen structure has a grey tone assigned thereto which is added to the information about the position and shape of the broadened screen structure,

d) this information about the broadened screen structures is superimposed in such a way that the grey tones are added point by point so that a grey tone is assigned to each point of the resulting screen structure and this information is stored so as to yield an "electronic contact screen",

e) this information is used to control a laser beam recorder which transfers the "electronic contact screen" onto a half-tone material.

20. A method for producing a film contact screen, characterized in that

a) the basic screen structure is produced by means of computer graphic techniques or by scanning photographic or graphic originals,

b) the position and shape of the screen elements for the basic screen structure is stored,

c) a grey tone or blackening pattern is defined and stored by means of computer graphic techniques for one or more cross-sections of a characteristic screen element,

d) this grey tone pattern is transferred to the overall screen structure and stored so as to obtain an "electronic contact screen,

e) this information is used to control a laser beam recorder which transfers the "electronic contact screen" onto a half-tone material.

21. A screened picture theme, produced according to any of the above claims, characterized in that the basic screen structure is a guilloche pattern having intertwinings, T-crossings and multiple crossings, mesh width a of the mesh resulting when lines cross and line width b being coordinated with each other in such a way that line width b is always smaller than half of mesh width a.

22. The screened picture theme according to claim 21, characterized in that the lines of the guilloche pattern present as printing ink on a carrier material consist of different ink layers so as to yield a stepped pyramid like cross-section.

23. The screened picture theme according to claim 22, characterized in that one or more ink layers consist of metallic, metameric, thermochrome or photochrome inks.

24. The screened picture theme according to claim 22, characterized in that part of the grey tone areas of the half-tone picture theme reproduced by the broadened screen structures are disposed on the front of a translucent carrier material and the other part on the back, so that the complete screened picture theme only appears in transmitted light.

**Revendications**

1. Procédé de tramage d'image en demi-teintes dans lequel les différentes demi-teintes ou grisés de l'image sont reproduits au moyen d'un élargissement symétrique des éléments de trame d'une structure de base-trame, caractérisé en ce que:

a. au départ de la structure de base-trame est produit un assortiment de structures-trames élargies, symétriquement correspondant au nombre de zones grisées de l'image qui sont à convertir, dont le degré d'élargissement croît par degrés,

b. l'évolution totale des grisés de l'image en demi-teintes est décomposée en zones grisées isolées,

c. à chacune des zones grisées définies en (b) est associée une structure-trame déterminée parmi les structures-trames élargies symétriquement en (a).

d. les structures-trames élargies, sont superposées, isolément ou sous forme rassemblée, aux zones grisées de l'image en demi-teintes qui leur sont associées en (c), qui peuvent également se présenter isolément ou sous forme rassemblée,

e. l'information résultant de cette superposition est stockée ou affichée, de telle sorte que les parties de l'image en demi-teintes qui présentent un grisé d'une des zones grisées choisies en (c) sont reproduites localement au moyen de la structure-trame élargie associée à cette zone grisée.

2. Procédé selon la revendication 1, caractérisé en ce que:

a. au départ de la structure de base-trame (1), un assortiment de structures-trames élargies symétriquement par degrés, correspondant au nombre de zones grisées de l'image qui sont à convertir, est produit sous la forme de trames-simili d'intensité structurelle croissante, qui se présentent comme un film négatif (9, 11) ou positif,

b. au départ de l'image qui est à tramer (13), est produit, comme un film tramé négatif (20, 22) ou positif, le même nombre de gammes des tons, dont chacune reproduit une zone grisée déterminée de l'image en demi-teintes,

c. la trame-simili avec la structure-trame la plus fortement élargie en (a) qui se présente comme un film négatif (9) ou positif, est placée en un arrangement de contact sur une trame non exposée à la lumière (24) en même temps que la gamme des tons obtenue en (b), qui se présente comme un film négatif (22), ou positif, qui reproduit les parties de l'image en demi-teintes avec les grisés les plus sombres,

d. cet arrangement est exposé à la lumière jusqu'à ce que se réalise un noircissement complet dans les zones du matériau tramé où l'arrangement est complètement transparent à la lumière, de telle sorte que la zone grisée la plus sombre de l'image en demi-teintes, déterminée par la gamme des tons, est reproduite par la structure-trame qui a la plus fort élargissement,

e. on procède de façon analogue avec les trames-simili, chaque fois qu'un élargissement décroissant comme obtenues en (a) et avec les gammes des tons obtenues en (b) qui reproduisent chaque fois une zone grisée plus claire de l'image en demi-teintes et avec chaque fois un nouveau matériau tramé non exposé à la lumière,

f. les matériaux tramés (25) qui se présentent comme un film positif ou négatif, dont chacun reproduit une autre zone grisée de l'image en demi-teintes au moyen d'un élargissement lui correspondant de la structure de base-trame, sont utilisés pour la production d'une image tramée globale (26) (fig. 1).

3. Procédé selon la revendication 2, caractérisé en ce que, pour chaque opération d'exposition à la lumière de l'arrangement gamme des tons/ structure-trame/matériau tramé dans l'étape (e) du procédé, l'exposition à la lumière se fait toujours sur un seul et même matériau tramé.

4. Procédé selon la revendication 1, caractérisé en ce que:

a. au départ de la structure de base-trame est produit un assortiment de structures-trames élargies symétriquement par degrés, correspondant au nombre de zones grisées de l'image qui sont à convertir, sous la forme de trames-simili d'intensité structurelle croissante, qui se présentent sous la forme d'un film négatif ou positif,

b. la trame-simili avec la structure-trame la plus faiblement élargie, qui se présente comme un film négatif ou positif, est placée dans un arrangement de contact sur un matériau tramé non exposé à la lumière, en même temps qu'un film en demi-teintes négatif ou positif, de l'image qui est à tramer,

c. cet arrangement est exposé à la lumière, jusqu'à ce que les zones grisées les plus claires de l'image en demi-teintes soient reproduites au moyen de la structure-trame avec le plus faible élargissement.

d. on procède également ainsi avec les trames-simili d'élargissement qui s'accroît chaque fois et avec chaque fois un nouveau matériau tramé non exposé à la lumière, la durée d'exposition à la lumière étant diminuée de telle sorte que des zones grisées plus sombres correspondantes de l'image en demi-teintes sont converties en cette structure-trame plus fortement élargie,

e. les matériaux tramés qui se présentent comme un film positif ou négatif, et dont chacun reproduit une autre zone grisée de l'image en demi-teintes au moyen d'un élargissement de la structure de base-trame qui correspond à cette zone, sont utilisés pour la production d'une image tramée globale.

5. Procédé selon la revendication 4, caractérisé en ce que, pour chaque opération d'exposition à la lumière de l'arrangement: négatif en demi-teintes/structure-trame/matériau tramé dans l'étape (e) du procédé, l'exposition à la lumière se fait toujours sur un seul et même matériau tramé.

6. Procédé selon la revendication 1, caractérisé en ce que:

a. au départ de la structure de base-trame sont produites des structures-trames élargies symétriquement par degrés, sous la forme de trames-simili d'intensité structurelle croissante, qui se présentent comme un film négatif (5, 7) ou positif,

b. chacune de ces trames-simili est, isolément, l'une après l'autre, placée en arrangement de contact sur un matériau tramé en demi-teintes adéquat (73) et chaque fois exposée à la lumière pour une durée d'exposition déterminée de telle sorte que l'on obtienne comme résultat une trame de contact positive (73) ou négative, qui présente une évolution du noircissement du profil de trame déterminé par le degré d'élargissement distinct des structures-trames isolées,

c. l'image en demi-teintes est tramée avec cette trame de contact de la manière connue (fig. 20).

7. Procédé selon l'une quelconque des revendications 1 à 6, caractérisé en ce que les structures-trames d'élargissement croissant sont produites par voie photographique au moyen d'une insolation adéquate de chaque fois un nouveau matériau tramé.

8. Procédé selon l'une quelconque des revendications 1 à 5, caractérisé en ce que les gammes de tons sont produites par voie photographique de la manière connue.

9. Procédé selon l'une quelconque des revendications 1 à 6, caractérisé en ce que la structure de base-trame et les structures-trames élargies sont réalisées grâce à des techniques informatiques graphiques et reportées grâce à un traceur à rayon laser dirigé sur chaque fois un nouveau matériau tramé.

10. Procédé selon l'une quelconque des revendications 1 à 5, caractérisé en ce que les gammes des tons sont obtenues au moyen d'une installation à balayage.

11. Procédé selon l'une quelconque des revendications 1 à 7, caractérisé en ce que, après le tramage de l'image en demi-teintes, la structure de base-trame est fidèlement recopiée dans l'image tramée.

12. Procédé selon la revendication 1, caractérisé en ce que:

a. la structure de base-trame et les structures-trames élargies sont réalisées grâce à des techniques informatiques graphiques ou au moyen d'un balayage de modèles photographiques ou graphiques,

b. la position et la forme des éléments de trame pour la structure de base-trame et les structures-trames élargies sont stockées séparément,

c. l'ensemble des grisés de l'image en demi-teintes est réparti en zones grisées et l'image en demi-teintes est balayée de telle sorte que les parties de l'image en demi-teintes qui présentent un grisé de l'une de ces zones, sont stockées séparément pour chaque zone grisée,

d. les zones grisées sont chaque fois associées à une structure-trame élargie,

e. les informations de structure-trame élargie et de la partie grisée associée de l'image en demi-teintes sont superposées point par point, séparément pour chaque zone grisée, de telle sorte qu'une information résultante est formée et stockée et qu'il s'y ajoute la donnée de savoir si à ce point se présentent une structure-trame et une partie d'image, de telle sorte que chaque partie grisée de l'image est reproduite au moyen de la structure-trame associée,

f. ces informations sur les parties grisées tramées isolées de l'image en demi-teintes sont utilisées pour produire une image tramée.

13. Procédé selon la revendication 12, caractérisé en ce que, avec les informations relatives aux parties grisées tramées de l'image en demi-teintes, séparément pour chaque zone grisée, est dirigé un traceur à rayon laser qui expose à la lumière les parties grisées tramées sur chaque fois des films-supports séparés, ou les reporte directement sur des plaques d'impression.

14. Procédé selon la revendication 12, caractérisé en ce que les différentes parties grisées tramées sont d'abord superposées et ensuite reportées sur un film-support ou sur une plaque d'impression.

15. Procédé selon la revendication 1, caractérisé en ce que:

a. la structure de base-trame et les structures-trames élargies sont produites grâce à des techniques informatiques graphiques ou au moyen d'un balayage de modèles photographiques ou graphiques,

b. la position et la forme des éléments de trame pour la structure de base-trame et les structures-trames élargies sont stockées séparément,

c. un grisé est associé à chaque structure-trame élargie et l'information relative à la position et à la forme de la structure-trame élargie s'y ajoute,

d. ces informations relatives aux structures-trames élargies sont superposées de telle manière que les grisés s'ajoutent point par point, de telle sorte qu'à chaque point de la structure-trame résultante est associé un grisé et que cette information est stockée, de façon à ce qu'il s'ensuit une «trame de contact électronique»,

e. un modèle en demi-teintes est balayé de telle sorte que, pour chaque point, on stocke séparément le grisé,

f. les informations relatives aux grisés de l'image en demi-teintes sont superposées avec les informations de la «trame de contact électronique», de telle sorte que, pour chaque point de cet arrangement superposé, les grisés s'ajoutent et que, lorsqu'on franchit une valeur-seuil pour ce point, une information positive est déstockée, de telle sorte que ces informations résultantes reproduisent l'image tramée.

16. Procédé de tramage d'images en demi-teintes, dans lequel les différentes demi-teintes ou grisés de l'image sont reproduits au moyen d'un élargissement des éléments de structure d'une structure de base-trame de forme quelconque, caractérisé en ce que:

a. la structure de base-trame est produite grâce à des techniques informatiques graphiques ou au moyen d'un balayage de modèles photographiques ou graphiques,

b. la position et la forme des éléments de trame pour la structure de base-trame sont stockées séparément,

c. une évolution des grisés ou du noircissement est définie et stockée grâce à des techniques informatiques graphiques pour une ou plusieurs sections d'un élément de trame caractéristique,

d. cette évolution des grisés est reportée et stockée sur la structure-trame totale, de telle sorte qu'on obtient une «trame de contact électronique»,

e. un modèle en demi-teintes est alors balayé, de telle sorte qu'un grisé est stocké pour chaque point,

f. les informations relatives aux grisés de l'image en demi-teintes sont alors superposées avec les informations de la «trame de contact électronique», de telle sorte que, pour chaque point de cet arrangement superposé, les grisés s'ajoutent et que, lors du franchissement d'une valeur-seuil pour ce point, une information positive est déstockée, de sorte que ces informations résultantes reproduisent l'image tramée.

17. Procédé selon l'une quelconque des revendications 15 ou 16, caractérisé en ce que, avec les informations stockées relatives à l'image en demi-teintes tramée, on dirige un traceur à rayon laser qui la reporte sur un film-support, un papier photographique, une plaque d'impression ou un matériau support.

18. Procédé pour la production d'un film-trame de contact, caractérisé en ce que:

a. au départ de la structure de base-trame sont produites des structures-trames élargies symétriquement, sous la forme de trames-simili d'intensité structurelle croissante qui se présentent comme un film négatif ou positif,

b. chacune de ces trames-simili est placée isolément, l'une après l'autre, en arrangement de contact sur un matériau en demi-teintes adéquat et chaque fois exposé à la lumière durant un temps déterminé, de telle sorte que l'on obtienne comme résultat une trame de contact positive ou négative, qui présente une évolution du noircissement du profil de trame déterminée et fixable avec précision par le degré d'élargissement distinct de la structure-trame isolée et des temps d'exposition.

19. Procédé de fabrication d'un film-trame de contact, caractérisé en ce que:

a. une structure de base-trame et des structures-trames élargies symétriquement sont réalisées grâce à des techniques informatiques graphiques ou au moyen du balayage de modèles photographiques ou graphiques,

b. la position et la forme des éléments de trame pour la structure de base-trame et les structures-trames élargies sont stockées séparément,

c. un grisé est associé à chaque structure-trame élargie et l'information relative à la position et à la forme de la structure-trame élargie s'y rajoute,

d. ces informations relatives aux structures-trames élargies sont superposées de telle façon que les grisés s'ajoutent point par point, de sorte qu'à chaque point de la structure-trame résultante est associé un grisé et que cette information est stockée, de façon à ce qu'il s'ensuit une «trame de contact électronique».

e. avec ces informations, est dirigé un traceur à rayon laser qui reporte la «trame de contact électronique» sur un matériau en demi-teintes.

20. Procédé de fabrication d'un film-trame de contact, caractérisé en ce que:

a. la structure de base-trame est réalisée grâce à des techniques informatiques graphiques ou au moyen du balayage de modèles photographiques ou graphiques,

b. la position et la forme des éléments de trame pour la structure de base-trame sont stockées,

c. une évolution des grisés ou du noircissement est définie et stockée grâce à des techniques informatiques graphiques pour une ou plusieurs sections d'un élément de trame caractéristique,

d. cette évolution des grisés est reportée et stockée sur la structure-trame totale, de telle sorte qu'on obtient une «trame de contact électronique»,

e. avec ces informations, est dirigé un traceur à rayon laser qui reporte la «trame de contact électronique» sur un matériau en demi-teintes.

21. L'image tramée, réalisée conformément à l'une quelconque des revendications précédentes, est caractérisée en ce que la structure de base-trame est un motif guilloché, qui présente des entrelacements, des croisements en T ou à plusieurs branches, dans lequel la largeur a des mailles qui se forment par le croisement des lignes, et l'intensité b des lignes, s'accordent l'une à l'autre de telle sorte que l'intensité b des lignes est toujours plus petite que la moitié de la largeur a des mailles.

22. L'image tramée conformément à la revendication 21 est caractérisée en ce que les lignes du motif guilloché qui se présentent comme des teintes d'impression sur un matériau support consistent en différentes couches de couleurs, de telle sorte qu'il s'ensuit une section en forme de pyramide de degrés.

23. L'image tramée conformément à la revendication 22 est caractérisée en ce qu'une ou plusieurs couches de couleurs consistent en couleurs métalliques, métamères, thermochromes ou photochromes.

24. L'image tramée conformément à la revendication 22 est caractérisée en ce qu'une partie de la zone grisée de l'image en demi-teintes reproduite au moyen des structures-trames élargies est placée sur le recto d'un matériau support transparent, et l'autre partie sur le verso, de telle sorte que l'image tramée complète n'apparaisse qu'en lumière passante.

FIG.1

FIG.2

FIG.3

FIG.4a)

FIG.4b)

FIG.5a)

FIG.5b)

FIG. 6

FIG. 7a)

FIG.7b)

27

28

FIG.8a)

29

30

FIG.8b)

2

32

33

FIG.9

34

B

f

e

d

o       a               b       c

G

FIG.10

44

17
43
11
36
38    12    39        40    24

FIG.11

FIG.12

45

46

39

0 085 066

47

MUSCHEL MUSCHEL MUSCHEL MUSCHEL MUSCHEL MUSCHEL MUSCHEL MUSCHEL
CHEL MUSCHEL MUSCHEL MUSCHEL MUSCHEL MUSCHEL MUSCHEL MUS
MUSCHEL MUSCHEL MUSCHEL MUSCHEL MUSCHEL MUSCHEL MUSCHEL MUSCHEL
CHEL MUSCHEL MUSCHEL MUSCHEL MUSCHEL MUSCHEL MUSCHEL MUS
MUSCHEL MUSCHEL MUSCHEL MUSCHEL MUSCHEL MUSCHEL MUSCHEL MUSCHEL
CHEL MUSCHEL MUSCHEL MUSCHEL MUSCHEL MUSCHEL MUSCHEL MUS

48

MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS
MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS
MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS

49

MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS
MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS
MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS

50

MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS
MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS
MUSCHELMUSCHELMUSCHELMUSCHELMUSCHELMUSCHELMUSCHELMUSCHEL
CHELMUSCHELMUSCHELMUSCHELMUSCHELMUSCHELMUSCHELMUS

51

**MUSCHELMUSCHELMUSCHELMUSCHELMUSCHELMUSCHELMUSCHELMUSCHEL**
**CHELMUSCHELMUSCHELMUSCHELMUSCHELMUSCHELMUSCHELMUS**
**MUSCHELMUSCHELMUSCHELMUSCHELMUSCHELMUSCHELMUSCHELMUSCHEL**
**CHELMUSCHELMUSCHELMUSCHELMUSCHELMUSCHELMUSCHELMUS**
**MUSCHELMUSCHELMUSCHELMUSCHELMUSCHELMUSCHELMUSCHELMUSCHEL**
**CHELMUSCHELMUSCHELMUSCHELMUSCHELMUSCHELMUSCHELMUS** FIG.13

0 085 066

FIG.14

56

57

58

59

FIG.15

FIG.16

60

47

FIG.17

FIG.18

FIG.19 a)

FIG.19 b)

FIG.19 c)

FIG.20

FIG.21

FIG.22

FIG.23

FIG.24